(19) Europäisches Patentamt
European Patent Office
Office européen des brevets

(11) EP 1 893 403 B1

(12) **EUROPÄISCHE PATENTSCHRIFT**

(45) Veröffentlichungstag und Bekanntmachung des Hinweises auf die Patenterteilung:
**11.03.2015 Patentblatt 2015/11**

(21) Anmeldenummer: **06763688.6**

(22) Anmeldetag: **13.06.2006**

(51) Int Cl.:
***B32B 7/00*** *(2006.01)* ***C08L 67/02*** *(2006.01)*
***C08G 83/00*** *(2006.01)*

(86) Internationale Anmeldenummer:
**PCT/EP2006/063167**

(87) Internationale Veröffentlichungsnummer:
**WO 2006/134115 (21.12.2006 Gazette 2006/51)**

(54) **MEHRKOMPONENTENFORMKÖRPER MIT POLYESTERSCHICHTEN**

MULTIPLE COMPONENT MOULDED BODY COMPRISING POLYESTER LAYERS

CORPS MOULE A PLUSIEURS COMPOSANTS, MUNI DE COUCHES POLYESTER

(84) Benannte Vertragsstaaten:
**AT BE BG CH CY CZ DE DK EE ES FI FR GB GR HU IE IS IT LI LT LU LV MC NL PL PT RO SE SI SK TR**

(30) Priorität: **14.06.2005 DE 102005027549**

(43) Veröffentlichungstag der Anmeldung:
**05.03.2008 Patentblatt 2008/10**

(73) Patentinhaber: **BASF SE**
**67056 Ludwigshafen (DE)**

(72) Erfinder:
- **EIPPER, Andreas**
**67067 Ludwigshafen (DE)**
- **BRUCHMANN, Bernd**
**67251 Freinsheim (DE)**
- **WEISS, Carsten**
**276252 Singapore (SG)**
- **VÖLKEL, Mark**
**68526 Ladenburg (DE)**
- **ROSENAU, Bernhard**
**67434 Neustadt (DE)**
- **GINSS, Christophe**
**F-67120 Wolxheim (FR)**
- **HÖFLI, Kurt**
**67069 Ludwigshafen (DE)**

(56) Entgegenhaltungen:
**WO-A-2006/042673**

Anmerkung: Innerhalb von neun Monaten nach Bekanntmachung des Hinweises auf die Erteilung des europäischen Patents im Europäischen Patentblatt kann jedermann nach Maßgabe der Ausführungsordnung beim Europäischen Patentamt gegen dieses Patent Einspruch einlegen. Der Einspruch gilt erst als eingelegt, wenn die Einspruchsgebühr entrichtet worden ist. (Art. 99(1) Europäisches Patentübereinkommen).

EP 1 893 403 B1

## Beschreibung

Die Erfindung betrifft ein verbessertes Verfahren zur Herstellung von Mehrkomponentenformkörpern und die hierbei erhältlichen Mehrkomponentenformkörper.

Demgemäß wurde ein Verfahren zur Herstellung von Mehrkomponentenformkörpern gefunden, welches dadurch gekennzeichnet ist, dass mindestens eine Schicht des Formkörpers aus einer thermoplastischen Formmasse aus

A) 10 bis 99,99 Gew.-% mindestens eines thermoplastischen Polyesters,
B) 0,01 bis 50 Gew.-%
B1) mindestens eines hoch- oder hyperverzweigten Polycarbonates mit einer OH-Zahl von 1 bis 600 mg KOH/g Polycarbonat (gemäß DIN 53240, Teil 2), oder
B2) mindestens eines hoch- oder hyperverzweigten Polyesters des Typs $A_xB_y$ mit x mindestens 1,1 und y mindestens 2,1 oder deren Mischungen und
C) 0 bis 60 Gew.-% weiterer Zusatzstoffe,

aufgebaut ist,
wobei die Summe der Gewichtsprozente der Komponenten A) bis C) 100 % ergibt.

Die Beschichtung von Polymeren mit Metallen stellt heutzutage für viele Anwendungen einen entscheidenden Verarbeitungsschritt dar. Sowohl für dekorative Anwendungen (Verpackungsfolien, Geschenkfolien, Sanitärarmaturen, dekorative Beschichtung von Gehäusen etc.), auf dem Elektroniksektor (z.B. EMV-Abschirmung, Leiterplattenherstellung etc.) als auch in der Beleuchtungstechnologie (z.B. Autoscheinwerfer-Reflektoren, reflektierende Teile bei Innenbeleuchtungseinheiten etc.) ist eine Metallisierung von Polymeroberflächen notwendig.

Die Metallisierung von Kunststoffen wurde bisher durch chemisch-galvanische Verfahren durchgeführt. Hierbei muss die Oberfläche durch Ätzen in Chromschwefelsäure vorbehandelt werden, was aufwändig und umweltgefährdend ist (Kunststoffe 1999, 53, 3). Um die giftige Chromschwefelsäure zu vermeiden, kann man durch Aufdampfverfahren im Vakuum (Physical vapour deposition, PVD) Kunststoffe physikalisch metallisieren. Bei Polyestern muss für diesen physikalischen Prozess eine teure Vorbehandlung durch z.B. Sauerstoff-Plasma durchgeführt werden, um eine ausreichende Haftung zu erreichen (Surface and Coatings Technology 1997, 372-377; J. Electrochemical Soc. 1997, 144, 3, 1131-1135; Nucl. Instr. Meth. Phys. Res. B 151 1999, 279-284).

Ein allgemeines Problem bei allen mehrschichtig aufgebauten Formteilen ist die Haftung der Schichten bei Kunststoffschichten im Verbund mit anderen Materialien verbesserungswürdig (s. z.B. US 6,497,959).

Aus WO 2006/042673 sind bereits thermoplastische Formmassen bekannt, bei denen mindestens ein Polyoxymethylenhomo- oder copolymerisat mit mindestens einem hoch- oder hyperverzweigten Polycarbonat oder mindestens einem hoch- oder hyperverzweigten Polyester oder deren Mischungen sowie weiteren Zusatzstoffe vermischt.

Aufgabe der vorliegenden Erfindung war es daher, die Haftung der Schichten von Mehrkomponentenformkörpern zu verbessern.

Demgemäß wurde ein Verfahren zur Herstellung von Mehrkomponentenformkörpern gefunden, welches dadurch gekennzeichnet ist, dass mindestens eine Schicht des Formkörpers aus einer thermoplastischen Formmasse aus

A) 10 bis 99,99 Gew.-% mindestens eines thermoplastischen Polyesters,
B) 0,01 bis 50 Gew.-%
B1) mindestens eines hoch- oder hyperverzweigten Polycarbonates mit einer OH-Zahl von 1 bis 600 mg KOH/g Polycarbonat (gemäß DIN 53240, Teil 2), oder
B2) mindestens eines hoch- oder hyperverzweigten Polyesters des Typs $A_xB_y$ mit x mindestens 1,1 und y mindestens 2,1
oder deren Mischungen und
C) 0 bis 60 Gew.-% weiterer Zusatzstoffe,

aufgebaut ist,
wobei die Summe der Gewichtsprozente der Komponenten A) bis C) 100 % ergibt.

Als Komponente (A) enthalten die erfindungsgemäßen Formmassen 10 bis 99,99, bevorzugt 30 bis 99,5 und insbesondere 30 bis 99,3 Gew.-% mindestens eines thermoplastischen Polyesters, welcher verschieden von B) ist.

Allgemein werden Polyester A) auf Basis von aromatischen Dicarbonsäuren und einer aliphatischen oder aromatischen Dihydroxyverbindung verwendet.

Eine erste Gruppe bevorzugter Polyester sind Polyalkylenterephthalate, insbesondere solche mit 2 bis 10 C-Atomen im Alkoholteil.

Derartige Polyalkylenterephthalate sind an sich bekannt und in der Literatur beschrieben. Sie enthalten einen aromatischen Ring in der Hauptkette, der von der aromatischen Dicarbonsäure stammt. Der aromatische Ring kann

auch substituiert sein, z.B. durch Halogen wie Chlor und Brom oder durch $C_1$-$C_4$-Alkylgruppen wie Methyl-, Ethyl-, i- bzw. n-Propyl- und n-, i- bzw. t-Butylgruppen.

Diese Polyalkylenterephthalate können durch Umsetzung von aromatischen Dicarbonsäuren, deren Estern oder anderen esterbildenden Derivaten mit aliphatischen Dihydroxyverbindungen in an sich bekannter Weise hergestellt werden.

Als bevorzugte Dicarbonsäuren sind 2,6-Naphthalindicarbonsäure, Terephthalsäure und Isophthalsäure oder deren Mischungen zu nennen. Bis zu 30 mol-%, vorzugsweise nicht mehr als 10 mol-% der aromatischen Dicarbonsäuren können durch aliphatische oder cycloaliphatische Dicarbonsäuren wie Adipinsäure, Azelainsäure, Sebacinsäure, Dodecandisäuren und Cyclohexandicarbonsäuren ersetzt werden.

Von den aliphatischen Dihydroxyverbindungen werden Diole mit 2 bis 6 Kohlenstoffatomen, insbesondere 1,2-Ethandiol, 1,3-Propandiol, 1,4-Butandiol, 1,6-Hexandiol, 1,4-Hexandiol, 1,4-Cyclohexandiol, 1,4-Cyclohexandimethanol und Neopentylglykol oder deren Mischungen bevorzugt.

Als besonders bevorzugte Polyester (A) sind Polyalkylenterephthalate, die sich von Alkandiolen mit 2 bis 6 C-Atomen ableiten, zu nennen. Von diesen werden insbesondere Polyethylenterephthalat, Polypropylenterephthalat und Polybutylenterephthalat oder deren Mischungen bevorzugt. Weiterhin bevorzugt sind PET und/oder PBT, welche bis zu 1 Gew.-%, vorzugsweise bis zu 0,75 Gew.-% 1,6-Hexandiol und/oder 2-Methyl-1,5-Pentandiol als weitere Monomereinheiten enthalten.

Die Viskositätszahl der Polyester (A) liegt im allgemeinen im Bereich von 50 bis 220, vorzugsweise von 80 bis 160 (gemessen in einer 0,5 gew.-%igen Lösung in einem Phenol/o-Dichlorbenzolgemisch (Gew.-Verh. 1:1 bei 25°C) gemäß ISO 1628.

Insbesondere bevorzugt sind Polyester, deren Carboxylendgruppengehalt bis zu 100 mval/kg, bevorzugt bis zu 50 mval/kg und insbesondere bis zu 40 mval/kg Polyester beträgt. Derartige Polyester können beispielsweise nach dem Verfahren der DE-A 44 01 055 hergestellt werden. Der Carboxylendgruppengehalt wird üblicherweise durch Titrationsverfahren (z.B. Potentiometrie) bestimmt.

Insbesondere bevorzugte Formmassen enthalten als Komponente A) eine Mischung aus Polyestern, welche verschieden von PBT sind, wie beispielsweise Polyethylenterephthalat (PET). Der Anteil z.B. des Polyethylenterephthalates beträgt vorzugsweise in der Mischung bis zu 50, insbesondere 10 bis 35 Gew.-%, bezogen auf 100 Gew.-% A).

Weiterhin ist es vorteilhaft PET Rezyklate (auch scrap-PET genannt) gegebenenfalls in Mischung mit Polyalkylenterephthalaten wie PBT einzusetzen.

Unter Rezyklaten versteht man im allgemeinen:

1) sog. Post Industrial Rezyklat: hierbei handelt es sich um Produktionsabfälle bei der Polykondensation oder bei der Verarbeitung z.B. Angüsse bei der Spritzgussverarbeitung, Anfahrware bei der Spritzgussverarbeitung oder Extrusion oder Randabschnitte von extrudierten Platten oder Folien.

2) Post Consumer Rezyklat: hierbei handelt es sich um Kunststoffartikel, die nach der Nutzung durch den Endverbraucher gesammelt und aufbereitet werden. Der mengenmäßig bei weitem dominierende Artikel sind blasgeformte PET Flaschen für Mineralwasser, Softdrinks und Säfte.

Beide Arten von Rezyklat können entweder als Mahlgut oder in Form von Granulat vorliegen. Im letzteren Fall werden die Rohrezyklate nach der Auftrennung und Reinigung in einem Extruder aufgeschmolzen und granuliert. Hierdurch wird meist das Handling, die Rieselfähigkeit und die Dosierbarkeit für weitere Verarbeitungsschritte erleichtert.

Sowohl granulierte als auch als Mahlgut vorliegende Rezyklate können zum Einsatz kommen, wobei die maximale Kantenlänge 10 mm, vorzugsweise kleiner 8 mm betragen sollte.

Aufgrund der hydrolytischen Spaltung von Polyestern bei der Verarbeitung (durch Feuchtigkeitsspuren) empfiehlt es sich, das Rezyklat vorzutrocknen. Der Restfeuchtegehalt nach der Trocknung beträgt vorzugsweise <0,2 %, insbesondere <0,05 %.

Als weitere Gruppe sind voll aromatische Polyester zu nennen, die sich von aromatischen Dicarbonsäuren und aromatischen Dihydroxyverbindungen ableiten.

Als aromatische Dicarbonsäuren eignen sich die bereits bei den Polyalkylenterephthalaten beschriebenen Verbindungen. Bevorzugt werden Mischungen aus 5 bis 100 mol-% Isophthalsäure und 0 bis 95 mol-% Terephthalsäure, insbesondere Mischungen von etwa 80 % Terephthalsäure mit 20 % Isophthalsäure bis etwa äquivalente Mischungen dieser beiden Säuren verwendet.

Die aromatischen Dihydroxyverbindungen haben vorzugsweise die allgemeine Formel

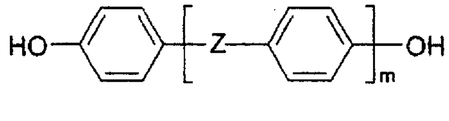

in der Z eine Alkylen- oder Cycloalkylengruppe mit bis zu 8 C-Atomen, eine Arylengruppe mit bis zu 12 C-Atomen, eine Carbonylgruppe, eine Sulfonylgruppe, ein Sauerstoff- oder Schwefelatom oder eine chemische Bindung darstellt und in der m den Wert 0 bis 2 hat. Die Verbindungen können an den Phenylengruppen auch $C_1$-$C_6$-Alkyl- oder Alkoxygruppen und Fluor, Chlor oder Brom als Substituenten tragen.

Als Stammkörper dieser Verbindungen seinen beispielsweise

Dihydroxydiphenyl,
Di-(hydroxyphenyl)alkan,
Di-(hydroxyphenyl)cycloalkan,
Di-(hydroxyphenyl)sulfid,
Di-(hydroxyphenyl)ether,
Di-(hydroxyphenyl)keton,
di-(hydroxyphenyl)sulfoxid,
$\alpha$,$\alpha$'-Di-(hydroxyphenyl)-dialkylbenzol,
Di-(hydroxyphenyl)sulfon, Di-(hydroxybenzoyl)benzol
Resorcin und
Hydrochinon sowie deren kernalkylierte oder kernhalogenierte Derivate genannt.

Von deisen werden

4,4'-Dihydroxydiphenyl,
2,4-Di-(4'-hydroxyphenyl)-2-methylbutan
$\alpha$,$\alpha$'-Di-(4-hydroxyphenyl)-p-diisopropylbenzol,
2,2-Di-(3'-methyl-4'-hydroxyphenyl)propan und
2,2-Di-(3'-chlor-4'-hydroxyphenyl)propan,

sowie insbesondere

2,2-Di-(4'-hydroxyphenyl)propan
2,2-Di-(3',5-dichlordihydroxyphenyl)propan,
1,1-Di-(4'-hydroxyphenyl)cyclohexan,
3,4'-Dihydroxybenzophenon,
4,4'-Dihydroxydiphenyfsulfon und
2,2-Di(3',5'-dimethyl-4'-hydroxyphenyl)propan

oder deren Mischungen bevorzugt.

Selbstverständlich kann man auch Mischungen von Polyalkylenterephthalaten und vollaromatischen Polyestern einsetzen. Diese enthalten im allgemeinen 20 bis 98 Gew.-% des Polyalkylenterephthalates und 2 bis 80 Gew.-% des vollaromatischen Polyesters.

Selbstverständlich können auch Polyesterblockcopolymere wie Copolyetherester verwendet werden. Derartige Produkte sind an sich bekannt und in der Literatur, z.B. in der US_A 3 651 014, beschrieben. Auch im Handel sind entsprechende Produkte erhältlich, z.B. Hytrel® (DuPont).

Als Polyester sollen erfindungsgemäß auch halogenfreie Polycarbonate verstanden werden. Geeignete halogenfreie Polycarbonate sind beispielsweise solche auf Basis von Diphenolen der allgemeinen Formel

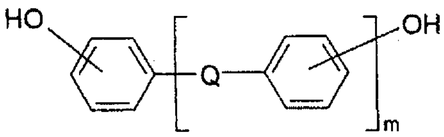

worin Q eine Einfachbindung, eine $C_1$- bis $C_8$-Alkylen-, eine $C_2$- bis $C_3$-Alkyliden-, eine $C_3$- bis $C_6$-Cycloalkylidengruppe, eine $C_6$- bis $C_{12}$-Arylengruppe sowie -O-, -S- oder -$SO_2$- bedeutet und m eine ganze Zahl von 0 bis 2 ist.

Die Diphenole können an den Phenylenresten auch Substituenten haben wie $C_1$- bis $C_6$-Alkyl oder $C_1$- bis $C_6$-Alkoxy.

Bevorzugte Diphenole der Formel sind beispielsweise Hydrochinon, Resorcin, 4,4'-Dihydroxydiphenyl, 2,2-Bis-(4-hydroxyphenyl)-propan, 2,4-Bis-(4-hydroxyphenyl)-2-methylbutan, 1,1-Bis-(4-hydroxyphenyl)-cyclohexan. Besonders bevorzugt sind 2,2-Bis-(4-hydroxyphenyl)-propan und 1,1-Bis-(4-hydroxyphenyl)-cyclohexan, sowie 1,1-Bis-(4-hydroxyphenyl)-3,3,5-trimethylcyclohexan.

Sowohl Homopolycarbonate als auch Copolycarbonate sind als Komponente A geeignet, bevorzugt sind neben dem Bisphenol A-Homopolymerisat die Copolycarbonate von Bisphenol A.

Die geeigneten Polycarbonate können in bekannter Weise verzweigt sein, und zwar vorzugsweise durch den Einbau von 0,05 bis 2,0 mol-%, bezogen auf die Summe der eingesetzten Diphenole, an mindestens trifunktionellen Verbindungen, beispielsweise solchen mit drei oder mehr als drei phenolischen OH-Gruppen.

Als besonders geeignet haben sich Polycarbonate erwiesen, die relative Viskositäten $\eta_{rei}$ von 1,10 bis 1,50, insbesondere von 1,25 bis 1,40 aufweisen. Dies entspricht mittleren Molekulargewichten $M_w$ (Gewichtsmittelwert) von 10 000 bis 200 000, vorzugsweise von 20 000 bis 80 000 g/mol.

Die Diphenole der allgemeinen Formel sind an sich bekannt oder nach bekannten Verfahren herstellbar.

Die Herstellung der Polycarbonate kann beispielsweise durch Umsetzung der Diphenole mit Phosgen nach dem Phasengrenzflächenverfahren oder mit Phosgen nach dem Verfahren in homogener Phase (dem sogenannten Pyridinverfahren) erfolgen, wobei das jeweils einzustellende Molekulargewicht in bekannter Weise durch eine entsprechende Menge an bekannten Kettenabbrechern erzielt wird. (Bezüglich polydiorganosiloxanhaltigen Polycarbonaten siehe beispielsweise DE-OS 33 34 782).

Geeignete Kettenabbrecher sind beispielsweise Phenol, p-t-Butylphenol aber auch langkettige Alkylphenole wie 4-(1,3-Tetramethyl-butyl)-phenol, gemäß DE-OS 28 42 005 oder Monoalkylphenole oder Dialkylphenole mit insgesamt 8 bis 20 C-Atomen in den Alkylsubstituenten gemäß DE-A 35 06 472, wie p-Nonylphenyl, 3,5-di-t-Butylphenol, p-t-Octylphenol, p-Dodecylphenol, 2-(3,5-dimethyl-heptyl)-phenol und 4-(3,5-Dimethylheptyl)-phenol.

Halogenfreie Polycarbonate im Sinne der vorliegenden Erfindung bedeutet, dass die Polycarbonate aus halogenfreien Diphenolen, halogenfreien Kettenabbrechern und gegebenenfalls halogenfreien Verzweigern aufgebaut sind, wobei der Gehalt an untergeordneten ppm-Mengen an verseifbarem Chlor, resultierend beispielsweise aus der Herstellung der Polycarbonate mit Phosgen nach dem Phasengrenzflächenverfahren, nicht als halogenhaltig im Sinne der Erfindung anzusehen ist. Derartige Polycarbonate mit ppm-Gehalten an verseifbarem Chlor sind halogenfreie Polycarbonate im Sinne vorliegender Erfindung.

Als weitere geeignete Komponenten A) seien amorphe Polyestercarbonate genannt, wobei Phosgen gegen aromatische Dicarbonsäureeinheiten wie isophthalsäure und/oder Terephthalsäureeinheiten, bei der Herstellung ersetzt wurde. Für nähere Einzelheiten sei an dieser Stelle auf die EP-A 711 810 verwiesen.

Weitere geeignete Copolycarbonate mit Cycloalkylresten als Monomereinheiten sind in der EP-A 365 916 beschrieben.

Weiterhin kann Bisphenol A durch Bisphenol TMC ersetzt werden. Derartige Polycarbonate sind unter dem Warenzeichen APEC HT® der Firma Bayer erhältlich.

Als Komponente B) enthalten die erfindungsgemäßen Formmassen 0,01 bis 50, vorzugsweise 0,5 bis 20 und insbesondere 0,7 bis 10 Gew.-% B1) mindestens eines hoch- oder hyperverzweigten Polycarbonates, mit einer OH-Zahl von 1 bis 600, vorzugsweise 10 bis 550 und insbesondere von 50 bis 550 mgKOH/g Polycarbonat (gemäß DIN 53240, Teil 2) oder mindestens eines hyperverzweigten Polyesters als Komponente B2) oder deren Mischungen wie nachstehend erläutert.

Unter hyperverzweigten Polycarbonaten B1) werden im Rahmen dieser Erfindung unvernetzte Makromoleküle mit Hydroxyl- und Carbonatgruppen verstanden, die sowohl strukturell als auch molekular uneinheitlich sind. Sie können auf der einen Seite ausgehend von einem Zentralmolekül analog zu Dendrimeren, jedoch mit uneinheitlicher Kettenlänge der Äste aufgebaut sein. Sie können auf der anderen Seite auch linear, mit funktionellen Seitengruppen, aufgebaut sein oder aber, als Kombination der beiden Extreme, lineare und verzweigte Molekülteile aufweisen. Zur Definition von dendrimeren und hyperverzweigten Polymeren siehe auch P.J. Flory, J. Am. Chem. Soc. 1952, 74, 2718 und H. Frey et al., Chem. Eur. J. 2000, 6, No. 14, 2499.

Unter "hyperverzweigt" wird im Zusammenhang mit der vorliegenden Erfindung verstanden, dass der Verzweigungsgrad (Degree of Branching, DB), dass heißt die mittlere Anzahl dendritischer Verknüpfungen plus mittlere Anzahl der Endgruppen pro Molekül, 10 bis 99.9 %, bevorzugt 20 bis 99 %, besonders bevorzugt 20 - 95 % beträgt.

Unter "dendrimer" wird im Zusammenhang mit der vorliegenden Erfindung verstanden, daß der Verzweigungsgrad 99,9 - 100% beträgt. Zur Definition des "Degree of Branching" siehe H. Frey et al., Acta Polym. 1997, 48, 30 und ist definiert als

$$DB = \frac{T+Z}{T+Z+L} \times 100\%,$$

(wobei T die mittlere Anzahl der terminalen Monomereinheiten, Z die mittlere Anzahl der verzweigten Monomereinheiten

und L die mittlere Anzahl der linearen Monomereinheiten in den Makromolekülen der jeweiligen Stoffe bedeuten).

Vorzugsweise weist die Komponente B1) ein Zahlenmittel des Molekulargewichtes $M_n$ von 100 bis 15000, vorzugsweise von 200 bis 12000 und insbesondere von 500 bis 10000 g/mol (GPC, Standard PMMA).

Die Glasübergangstemperatur Tg beträgt insbesondere von -80°C bis +140, vorzugsweise von -60 bis 120°C (gemäß DSC, DIN 53765).

Insbesondere beträgt die Viskosität (mPas) bei 23°C (gemäß DIN 53019) von 50 bis 200000, insbesondere von 100 bis 150000 und ganz besonders bevorzugt von 200 bis 100000.

Die Komponente B1) ist vorzugsweise erhältlich durch ein Verfahren, welches mindestens die folgenden Schritte umfasst:

a) Umsetzung mindestens eines organischen Carbonats (A) der allgemeinen Formel $RO[(CO)]_nOR$ mit mindestens einem aliphatischen, aliphatisch/aromatisch oder aromatischen Alkohol (B), welcher mindestens 3 OH-Gruppen aufweist, unter Eliminierung von Alkoholen ROH zu einem oder mehreren Kondensationsprodukten (K), wobei es sich bei R jeweils unabhängig voreinander um einen geradkettigen oder verzweigten aliphatischen, aromatisch/aliphatisch oder aromatischen Kohlenwasserstoffrest mit 1 bis 20 C-Atomen handelt, und wobei die Reste R auch unter Bildung eines Ringes miteinander verbunden sein können und n eine ganze Zahl zwischen 1 und 5 darstellt, oder

ab) Umsetzung von Phosgen, Diphosgen oder Triphosgen mit o.g. Alkohol (B) unter Chlorwasserstoffeliminierung sowie

b) intermolekulare Umsetzung der Kondensationsprodukte (K) zu einem hochfunktionellen, hoch- oder hyperverzweigten Polycarbonat,

wobei das Mengenverhältnis der OH-Gruppen zu den Carbonaten im Reaktionsgemisch so gewählt wird, dass die Kondensationsprodukte (K) im Mittel entweder eine Carbonatgruppe und mehr als eine OH-Gruppe oder eine OH-Gruppe und mehr als eine Carbonatgruppe aufweisen.

Als Ausgangsmaterial kann Phosgen, Diphosgen oder Triphosgen eingesetzt werden, wobei organische Carbonate bevorzugt sind.

Bei den Resten R der als Ausgangsmaterial eingesetzten organischen Carbonate (A) der allgemeinen Formel $RO(CO)_nOR$ handelt es sich jeweils unabhängig voneinander um einen geradkettigen oder verzweigten aliphatischen, aromatisch/aliphatisch oder aromatischen Kohlenwasserstoffrest mit 1 bis 20 C-Atomen handelt. Die beiden Reste R können auch unter Bildung eines Ringes miteinander verbunden sein. Bevorzugt handelt es sich um einen aliphatischen Kohlenwasserstoffrest und besonders bevorzugt um einen geradkettigen oder verzweigten Alkylrest mit 1 bis 5 C-Atomen, oder um einen substituierten oder unsubstituierten Phenylrest.

Insbesondere werden einfache Carbonate der Formel $RO(CO)_nOR$ eingesetzt; n beträgt vorzugsweise 1 bis 3, insbesondere 1.

Dialkyl- oder Diarylcarbonate können zum Beispiel hergestellt werden aus der Reaktion von aliphatischen, araliphatischen oder aromatischen Alkoholen, vorzugsweise Monoalkoholen mit Phosgen. Weiterhin können sie auch über oxidative Carbonylierung der Alkohole oder Phenole mittels CO in Gegenwart von Edelmetallen, Sauerstoff oder $NO_x$ hergestellt werden. Zu Herstellmethoden von Diaryl- oder Dialkylcarbonaten siehe auch "Ullmann's Encyclopedia of Industrial Chemistry", 6th Edition, 2000 Electronic Release, Verlag Wiley-VCH.

Beispiele geeigneter Carbonate umfassen aliphatische, aromatisch/aliphatische oder aromatische Carbonate wie Ethylencarbonat, 1,2- oder 1,3-Propylencarbonat, Diphenylcarbonat, Ditolylcarbonat, Dixylylcarbonat, Dinaphthylcarbonat, Ethylphenylcarbonat, Dibenzylcarbonat, Dimethylcarbonat, Diethylcarbonat, Dipropylcarbonat, Dibutylcarbonat, Diisobutylcarbonat, Dipentylcarbonat, Dihexylcarbonat, Dicyclohexylcarbonat, Diheptylcarbonat, Dioctylcarbonat, Didecylacarbonat oder Didodecylcarbonat.

Beispiele für Carbonate, bei denen n größer 1 ist, umfassen Dialkyldicarbonate, wie Di(-t-butyl)dicarbonat oder Dialkyltricarbonate wie Di(-t-butyltricarbonat).

Bevorzugt werden aliphatische Carbonate eingesetzt, insbesondere solche, bei denen die Reste 1 bis 5 C-Atome umfassen, wie zum Beispiel Dimethylcarbonat, Diethylcarbonat, Dipropylcarbonat, Dibutylcarbonat oder Diisobutylcarbonat.

Die organischen Carbonate werden mit mindestens einem aliphatischen Alkohol (B), welcher mindestens 3 OH-Gruppen aufweist oder Gemischen zweier oder mehrerer verschiedener Alkohole umgesetzt.

Beispiele für Verbindungen mit mindestens drei OH-Gruppen umfassen Glycerin, Trimethylolmethan, Trimethylolethan, Trimethylolpropan, 1,2,4-Butantriol, Tris(hydroxymethyl)amin, Tris(hydroxyethyl)amin, Tris(hydroxypropyl)amin, Pentaerythrit, Diglycerin, Triglycerin, Polyglycerine, Bis(tri-methylolpropan), Tris(hydroxymethyl)isocyanurat, Tris(hydroxyethyl)isocyanurat, Phloroglucinol" Trihydroxytoluol, Trihydroxydimethylbenzol, Phloroglucide, Hexahydroxybenzol, 1,3,5-Benzoltrimethanol, 1,1,1-Tris(4'-hydroxyphenyl)methan, 1,1,1-Tris(4'-hydroxyphenyl)ethan, Bis(tri-methylolpropan) oder Zucker, wie zum Beispiel Glucose, tri- oder höherfunktionelle Polyetherole auf Basis tri- oder höherfunktioneller Alkohole und Ethylenoxid, Propylenoxid oder Butylenoxid, oder Polyesterole. Dabei sind Glycerin, Trimethylolethan, Trimethylolpropan, 1,2,4-Butantriol, Pentaerythrit, sowie deren Polyetherole auf Basis von Ethylenoxid oder Propylenoxid besonders bevorzugt.

Diese mehrfunktionellen Alkohole können auch in Mischung mit difunktionellen Alkoholen (B) eingesetzt werden, mit der Maßgabe, dass die mittlere OH-Funktionalität aller eingesetzten Alkohole zusammen größer als 2 ist. Beispiele geeigneter Verbindungen mit zwei OH-Gruppen umfassen Ethylenglykol, Diethylenglykol, Triethylenglykol, 1,2-und 1,3-Propandiol, Dipropylenglykol, Tripropylenglykol, Neopentylglykol, 1,2-, 1,3- und 1,4-Butandiol, 1,2-, 1,3- und 1,5-Pentandiol, Hexandiol, Cyclopentandiol, Cyclohexandiol, Cyclohexandimethanol, Bis(4-Hydroxycyclohexyl)methan, Bis(4-Hydroxycyclohexyl)ethan, 2,2-Bis(4-Hydroxycyclohexyl)propan, 1,1'-Bis(4-Hydroxyphenyl)-3,3-5-trimethylcyclohexan, Resorcin, Hydrochinon, 4,4'-Dihydroxyphenyl, Bis-(4-Bis(hydroxyphenyl)sulfid, Bis(4-Hydroxyphenyl)sulfon, Bis(hydroxymethyl)benzol, Bis(hydroxymethyl)toluol, Bis(p-hydroxyphenyl)methan, Bis(p-hydroxyphenyl)ethan, 2,2-Bis(p-hydroxyphenyl)propan, 1,1-Bis(p-hydroxyphenyl)cyclohexan, Dihydroxybenzophenon, difunktionelle Polyetherpolyole auf Basis Ethylenoxid, Propylenoxid, Butylenoxid oder deren Gemische, Polytetrahydrofuran, Polycaprolacton oder Polyesterole auf Basis von Diolen und Dicarbonsäuren.

Die Diole dienen zur Feineinstellung der Eigenschaften des Polycarbonates. Falls difunktionelle Alkohole eingesetzt werden, wird das Verhältnis von difunktionellen Alkoholen B') zu den mindestens trifunktionellen Alkoholen (B) vom Fachmann je nach den gewünschten Eigenschaften des Polycarbonates festgelegt. Im Regelfalle beträgt die Menge des oder der Alkohole (B') 0 bis 50 mol-% bezüglich der Gesamtmenge aller Alkohole (B) und (B') zusammen. Bevorzugt beträgt die Menge 0 bis 45 mol-%, besonders bevorzugt 0 bis 35 mol-% und ganz besonders bevorzugt 0 bis 30 mol-%.

Die Reaktion von Phosgen, Diphosgen oder Triphosgen mit dem Alkohol oder Alkoholgemisch erfolgt in der Regel unter Eliminierung von Chlorwasserstoff, die Reaktion der Carbonate mit dem Alkohol oder Alkoholgemisch zum erfindungsgemäßen hochfunktionellen hochverzweigten Polycarbonat erfolgt unter Eliminierung des monofunktionellen Alkohols oder Phenols aus dem Carbonat-Molekül.

Die nach dem erfindungsgemäßen Verfahren gebildeten hochfunktionellen hochverzweigten Polycarbonate sind nach der Reaktion, also ohne weitere Modifikation, mit Hydroxylgruppen und/oder mit Carbonatgruppen terminiert. Sie lösen sich gut in verschiedenen Lösemitteln, zum Beispiel in Wasser, Alkoholen, wie Methanol, Ethanol, Butanol, Alkohol/Wasser-Mischungen, Aceton, 2-Butanon, Essigester, Butylacetat, Methoxypropylacetat, Methoxyethylacetat, Tetrahydrofuran, Dimethylformamid, Dimethylacetamid, N-Methylpyrrolidon, Ethylencarbonat oder Propylencarbonat.

Unter einem hochfunktionellen Polycarbonat ist im Rahmen dieser Erfindung ein Produkt zu verstehen, das neben den Carbonatgruppen, die das Polymergerüst bilden, end- oder seitenständig weiterhin mindestens drei, bevorzugt mindestens sechs, mehr bevorzugt mindestens zehn funktionelle Gruppen aufweist. Bei den funktionellen Gruppen handelt es sich um Carbonatgruppen und/oder um OH-Gruppen. Die Anzahl der end- oder seitenständigen funktionellen Gruppen ist prinzipiell nach oben nicht beschränkt, jedoch können Produkte mit sehr hoher Anzahl funktioneller Gruppen unerwünschte Eigenschaften, wie beispielsweise hohe Viskosität oder schlechte Löslichkeit, aufweisen. Die hochfunktionellen Polycarbonate der vorliegenden Erfindung weisen zumeist nicht mehr als 500 end- oder seitenständige funktionelle Gruppen, bevorzugt nicht mehr als 100 end oder seitenständige funktionelle Gruppen auf.

Bei der Herstellung der hochfunktionellen Polycarbonate B1) ist es notwendig, das Verhältnis von den OH-Gruppen enthaltenden Verbindungen zu Phosgen oder Carbonat so einzustellen, dass das resultierende einfachste Kondensationsprodukt (im weiteren Kondensationsprodukt (K) genannt) im Mittel entweder eine Carbonatgruppe oder Carbamoylgruppe und mehr als eine OH-Gruppe oder eine OH-Gruppe und mehr als eine Carbonatgruppe oder Carbamoylgruppe enthält. Die einfachste Struktur des Kondensationsproduktes (K) aus einem Carbonat (A) und einem Di- oder Polyalkohol (B) ergibt dabei die Anordnung $XY_n$ oder $Y_nX$, wobei X eine Carbonatgruppe, Y eine Hydroxyl-Gruppe und n in der Regel eine Zahl zwischen 1 und 6, vorzugsweise zwischen 1 und 4, besonders bevorzugt zwischen 1 und 3 darstellt. Die reaktive Gruppe, die dabei als einzelne Gruppe resultiert, wird im folgenden generell "fokale Gruppe" genannt.

Liegt beispielsweise bei der Herstellung des einfachsten Kondensationsproduktes (K) aus einem Carbonat und einem zweiwertigen Alkohol das Umsetzungsverhältnis bei 1:1, so resultiert im Mittel ein Molekül des Typs XY, veranschaulicht durch die allgemeine Formel 1.

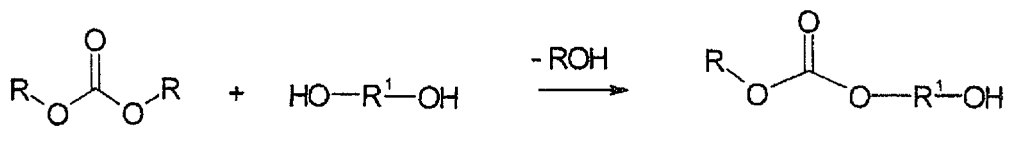


1

Bei der Herstellung des Kondensationsproduktes (K) aus einem Carbonat und einem dreiwertigen Alkohol bei einem Umsetzungsverhältnis von 1 : 1 resultiert im Mittel ein Molekül des Typs $XY_2$, veranschaulicht durch die allgemeine

Formel 2. Fokale Gruppe ist hier eine Carbonatgruppe.

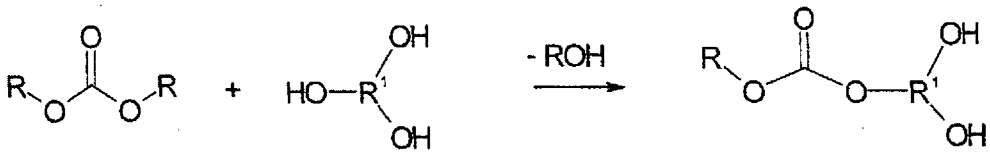


2

Bei der Herstellung des Kondensationsproduktes (K) aus einem Carbonat und einem vierwertigen Alkohol ebenfalls mit dem Umsetzungsverhältnis 1 : 1 resultiert im Mittel ein Molekül des Typs $XY_3$, veranschaulicht durch die allgemeine Formel 3. Fokale Gruppe ist hier eine Carbonatgruppe.

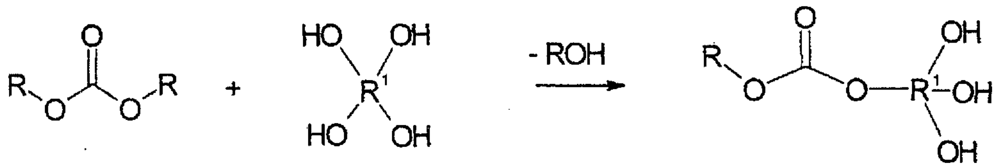


3

In den Formeln 1 bis 3 hat R die eingangs definierte Bedeutung und $R^1$ steht für einen aliphatischen oder aromatischen Rest.

Weiterhin kann die Herstellung des Kondensationsprodukts (K) zum Beispiel auch aus einem Carbonat und einem dreiwertigen Alkohol, veranschaulicht durch die allgemeine Formel 4, erfolgen, wobei das Umsetzungsverhältnis bei molar 2:1 liegt. Hier resultiert im Mittel ein Molekül des Typs $X_2Y$, fokale Gruppe ist hier eine OH-Gruppe. In der Formel 4 haben R und $R^1$ die gleiche Bedeutung wie in den Formeln 1 bis 3.

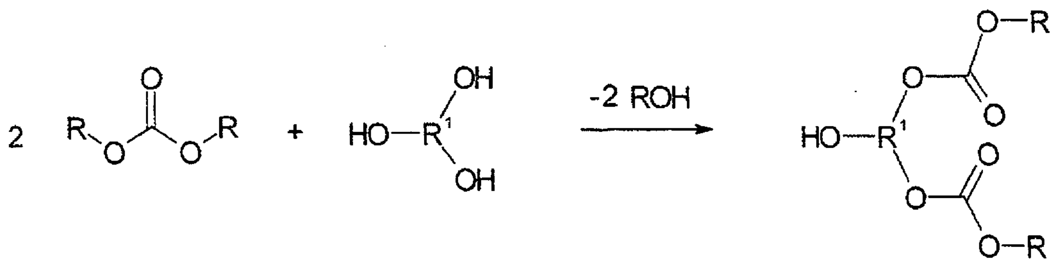


4

Werden zu den Komponenten zusätzlich difunktionelle Verbindungen, z.B. ein Dicarbonat oder ein Diol gegeben, so bewirkt dies eine Verlängerung der Ketten, wie beispielsweise in der allgemeinen Formel 5 veranschaulicht. Es resultiert wieder im Mittel ein Molekül des Typs $XY_2$, fokale Gruppe ist eine Carbonatgruppe.

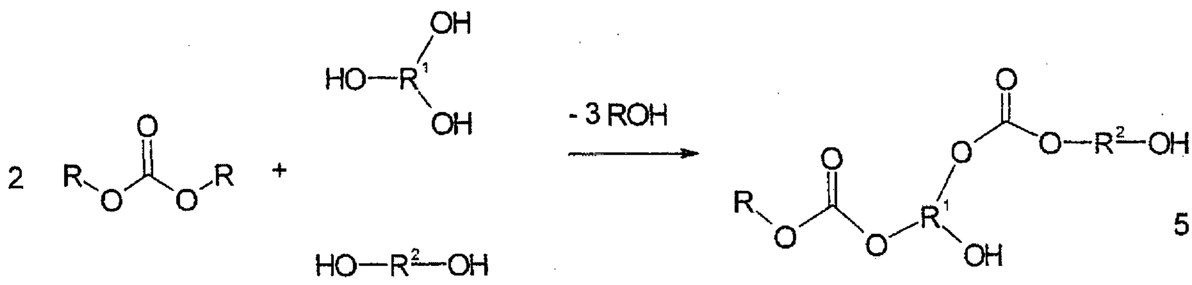


5

In Formel 5 bedeutet $R^2$ einen organischen, bevorzugt aliphatischen Rest, R und $R^1$ sind wie vorstehend beschrieben definiert.

Es können auch mehrere Kondensationsprodukte (K) zur Synthese eingesetzt werden. Hierbei können einerseits mehrere Alkohole beziehungsweise mehrere Carbonate eingesetzt werden. Weiterhin lassen sich durch die Wahl des Verhältnisses der eingesetzten Alkohole und der Carbonate bzw. der Phosgene Mischungen verschiedener Kondensationsprodukte unterschiedlicher Struktur erhalten. Dies sei am Beispiel der Umsetzung eines Carbonates mit einem dreiwertigen Alkohol beispielhaft erläutert. Setzt man die Ausgangsprodukte im Verhältnis 1:1 ein, wie in (II) dargestellt, so erhält man ein Molekül $XY_2$. Setzt man die Ausgangsprodukte im Verhältnis 2:1 ein, wie in (IV) dargestellt,

so erhält man ein Molekül $X_2Y$. Bei einem Verhältnis zwischen 1:1 und 2:1 erhält man eine Mischung von Molekülen $XY_2$ und $X_2Y$.

Die beispielhaft in den Formeln 1 - 5 beschriebenen einfachen Kondensationsprodukte (K) reagieren erfindungsgemäß bevorzugt intermolekular unter Bildung von hochfunktionellen Polykondensationsprodukten, im folgenden Polykondensationsprodukte (P) genannt. Die Umsetzung zum Kondensationsprodukt (K) und zum Polykondensationsprodukt (P) erfolgt üblicherweise bei einer Temperatur von 0 bis 250 °C, bevorzugt bei 60 bis 160°C in Substanz oder in Lösung. Dabei können allgemein alle Lösungsmittel verwendet werden, die gegenüber den jeweiligen Edukten inert sind. Bevorzugt verwendet werden organische Lösungsmittel, wie zum Beispiel Decan, Dodecan, Benzol, Toluol, Chlorbenzol, Xylol, Dimethylformamid, Dimethylacetamid oder Solventnaphtha.

In einer bevorzugten Ausführungsform wird die Kondensationsreaktion in Substanz durchgeführt. Der bei der Reaktion freiwerdende monofunktionelle Alkohol ROH oder das Phenol, kann zur Beschleunigung der Reaktion destillativ, gegebenenfalls bei vermindertem Druck, aus dem Reaktionsgleichgewicht entfernt werden.

Falls Abdestillieren vorgesehen ist, ist es regelmäßig empfehlenswert, solche Carbonate einzusetzen, welche bei der Umsetzung Alkohole ROH mit einem Siedepunkt von weniger als 140°C freisetzen.

Zur Beschleunigung der Reaktion können auch Katalysatoren oder Katalysatorgemische zugegeben werden. Geeignete Katalysatoren sind Verbindungen, die zum Veresterungs- oder Umesterungsreaktionen katalysieren, zum Beispiel Alkalihydroxide, Alkalicarbonate, Alkalihydrogencarbonate, vorzugsweise des Natriums, Kaliums oder Cäsiums, tertiäre Amine, Guanidine, Ammoniumverbindungen, Phosphoniumverbindungen, Aluminium-, Zinn-, Zink, Titan-, Zirkon- oder Wismut-organische Verbindungen, weiterhin sogenannte Doppelmetallcyanid (DMC)-Katalysatoren, wie zum Beispiel in der DE 10138216 oder in der DE 10147712 beschrieben.

Vorzugsweise werden Kaliumhydroxid, Kaliumcarbonat, Kaliumhydrogencarbonat, Diazabicyclooctan (DABCO), Diazabicyclononen (DBN), Diazabicycloundecen (DBU), Imidazole, wie Imidazol, 1-Methylimidazol oder 1,2-Dimethylimidazol, Titan-tetrabutylat, Titantetraisopropylat, Dibutylzinnoxid, Dibutylzinn-dilaurat, Zinndioctoat, Zirkonacetylacetonat oder Gemische davon eingesetzt.

Die Zugabe des Katalysators erfolgt im allgemeinen in einer Menge von 50 bis 10000, bevorzugt von 100 bis 5000 Gew. ppm bezogen auf die Menge des eingesetzten Alkohols oder Alkoholgemisches.

Ferner ist es auch möglich, sowohl durch Zugabe des geeigneten Katalysators, als auch durch Wahl einer geeigneten Temperatur die intermolekulare Polykondensationsreaktion zu steuern. Weiterhin lässt sich über die Zusammensetzung der Ausgangskomponenten und über die Verweilzeit das mittlere Molekulargewicht des Polymeren (P) einstellen.

Die Kondensationsprodukte (K) bzw. die Polykondensationsprodukte (P), die bei erhöhter Temperatur hergestellt wurden, sind bei Raumtemperatur üblicherweise über einen längeren Zeitraum stabil.

Aufgrund der Beschaffenheit der Kondensationsprodukte (K) ist es möglich, dass aus der Kondensationsreaktion Polykondensationsprodukte (P) mit unterschiedlichen Strukturen resultieren können, die Verzweigungen, aber keine Vernetzungen aufweisen. Ferner weisen die Polykondensationsprodukte (P) im Idealfall entweder eine Carbonatgruppe als fokale Gruppe und mehr als zwei OH-Gruppen oder aber eine OH-Gruppe als fokale Gruppe und mehr als zwei Carbonatgruppen auf. Die Anzahl der reaktiven Gruppen ergibt sich dabei aus der Beschaffenheit der eingesetzten Kondensationsprodukte (K) und dem Polykondensationsgrad.

Beispielsweise kann ein Kondensationsprodukt (K) gemäß der allgemeinen Formel 2 durch dreifache intermolekulare Kondensation zu zwei.verschiedenen Polykondensationsprodukten (P), die in den allgemeinen Formeln 6 und 7 wiedergegeben werden, reagieren.

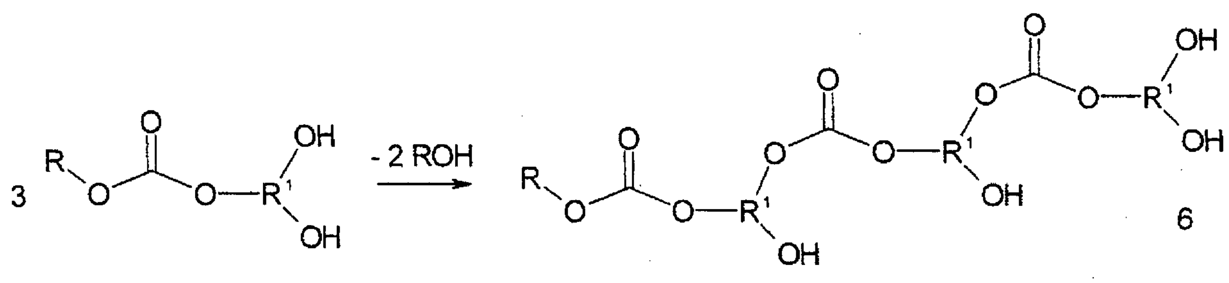


6

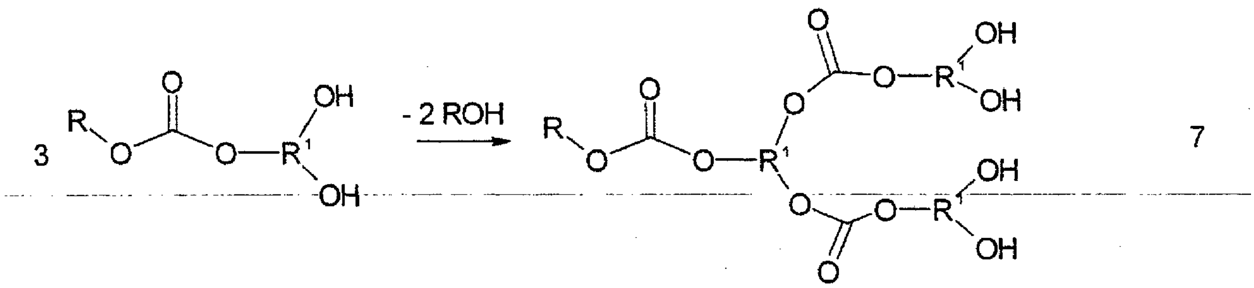

7

In Formel 6 und 7 sind R und $R^1$ wie vorstehend definiert.

Zum Abbruch der intermolekularen Polykondensationsreaktion gibt es verschiedene Möglichkeiten. Beispielsweise kann die Temperatur auf einen Bereich abgesenkt werden, in dem die Reaktion zum Stillstand kommt und das Produkt (K) oder das Polykondensationsprodukt (P) lagerstabil ist.

Weiterhin kann man den Katalysator deaktivieren, bei basischen z.B. durch Zugabe von Lewissäuren oder Protonensäuren.

In einer weiteren Ausführungsform kann, sobald aufgrund der intermolekularen Reaktion des Kondensationsproduktes (K) ein Polykondensationsprodukt (P) mit gewünschten Polykondensationsgrad vorliegt, dem Produkt (P) zum Abbruch der Reaktion ein Produkt mit gegenüber der fokalen Gruppe von (P) reaktiven Gruppen zugesetzt werden. So kann bei einer Carbonatgruppe als fokaler Gruppe zum Beispiel ein Mono-, Di- oder Polyamin zugegeben werden. Bei einer Hydroxylgruppe als fokaler Gruppe kann dem Produkt (P) beispielsweise ein Mono-, Di- oder Polyisocyanat, eine Epoxydgruppen enthaltende Verbindung oder ein mit OH-Gruppen reaktives Säurederivat zugegeben werden.

Die Herstellung der erfindungsgemäßen hochfunktionellen Polycarbonate erfolgt zumeist in einem Druckbereich von 0,1 mbar bis 20 bar, bevorzugt bei 1 mbar bis 5 bar, in Reaktoren oder Reaktorkaskaden, die im Batchbetrieb, halbkontinuierlich oder kontinuierlich betrieben werden.

Durch die vorgenannte Einstellung der Reaktionsbedingungen und gegebenenfalls durch die Wahl des geeigneten Lösemittels können die erfindungsgemäßen Produkte nach der Herstellung ohne weitere Reinigung weiterverarbeitet werden.

In einer weiteren bevorzugten Ausführungsform wird das Produkt gestrippt, das heißt, von niedermolekularen, flüchtigen Verbindungen befreit. Dazu kann nach Erreichen des gewünschten Umsatzgrades der Katalysator optional deaktiviert und die niedermolekularen flüchtigen Bestandteile, z.B. Monoalkohole, Phenole, Carbonate, Chlorwasserstoff oder leichtflüchtige oligomere oder cyclische Verbindungen destillativ, gegebenenfalls unter Einleitung eines Gases, vorzugsweise Stickstoff, Kohlendioxid oder Luft, gegebenenfalls bei vermindertem Druck, entfernt werden.

In einer weiteren bevorzugten Ausführungsform können die erfindungsgemäßen Polycarbonate neben den bereits durch die Reaktion erhaltenden funktionellen Gruppen weitere funktionelle Gruppen erhalten. Die Funktionalisierung kann dabei während des Molekulargewichtsaufbaus oder auch nachträglich, d.h. nach Beendigung der eigentlichen Polykondensation erfolgen.

Gibt man vor oder während des Molekulargewichtsaufbaus Komponenten zu, die neben Hydroxyl- oder Carbonatgruppen weitere funktionelle Gruppen oder funktionelle Elemente besitzen, so erhält man ein Polycarbonat-Polymer mit statistisch verteilten von den Carbonat-oder Hydroxylgruppen verschiedenen Funktionalitäten.

Derartige Effekte lassen sich zum Beispiel durch Zusatz von Verbindungen während der Polykondensation erzielen, die neben Hydroxylgruppen, Carbonatgruppen oder Carbamoylgruppen weitere funktionelle Gruppen oder funktionelle Elemente, wie Mercaptogruppen, primäre, sekundäre oder tertiäre Aminogruppen, Ethergruppen, Derivate von Carbonsäuren, Derivate von Sulfonsäuren, Derivate von Phosphonsäuren, Silangruppen, Siloxangruppen, Arylreste oder langkettige Alkylreste tragen. Zur Modifikation mittels Carbamat-Gruppen lassen sich beispielsweise Ethanolamin, Propanolamin, Isopropanolamin, 2-(Butylamino)ethanol, 2-(Cyclohexylamino)ethanol, 2-Amino-1-butanol, 2-(2'-Aminoethoxy)ethanol oder höhere Alkoxylierungsprodukte des Ammoniaks, 4-Hydroxy-piperidin, 1-Hydroxyethylpiperazin, Diethanolamin, Dipropanolamin, Diisopropanol-amin, Tris(hydroxymethyl)aminomethan, Tris(hydroxyethyl)amino-methan, Ethylen-diamin, Propylendiamin, Hexamethylendiamin oder Isophorondiamin verwenden.

Für die Modifikation mit Mercaptogruppen lässt sich zum Beispiel Mercaptoethanol einsetzten. Tertiäre Aminogruppen lassen sich zum Beispiel durch Einbau von N-Methyldiethanolamin, N-Methyldipropanolamin oder N,N-Dimethylethanolamin erzeugen. Ethergruppen können zum Beispiel durch Einkondensation von di- oder höherfunktionellen Polyetherolen generiert werden. Durch Reaktion mit langkettigen Alkandiolen lassen sich langkettige Alkylreste einbringen, die Reaktion mit Alkyl- oder Aryldiisocyanaten generiert Alkyl-, Aryl- und Urethangruppen oder Harnstoffgruppen aufweisende Polycarbonate.

Durch Zugabe von Dicarbonsäuren, Tricarbonsäuren, z.B. Terephthalsäuredimethylester oder Tricarbonsäureester lassen sich Estergruppen erzeugen.

Eine nachträgliche Funktionalisierung kann man erhalten, indem das erhaltene hochfunktionelle, hoch- oder hyperverzweigte Polycarbonat in einem zusätzlichen Verfahrensschritt (Schritt c)) mit einem geeigneten Funktionalisierungsreagenz, welches mit den OH- und/oder Carbonat-Gruppen oder Carbamoylgruppen des Polycarbonates reagieren kann, umsetzt.

Hydroxylgruppen enthaltende hochfunktionelle, hoch oder hyperverzweigte Polycarbonate können zum Beispiel durch Zugabe von Säuregruppen- oder Isocyanatgruppen enthaltenden Molekülen modifiziert werden. Beispielsweise lassen sich Säuregruppen enthaltende Polycarbonate durch Umsetzung mit Anhydridgruppen enthaltenden Verbindungen erhalten.

Weiterhin können Hydroxylgruppen enthaltende hochfunktionelle Polycarbonate auch durch Umsetzung mit Alkylenoxiden, zum Beispiel Ethylenoxid, Propylenoxid oder Butylenoxid, in hochfunktionelle Polycarbonat-Polyetherpolyole überführt werden.

Ein großer Vorteil des Verfahren liegt in seiner Wirtschaftlichkeit. Sowohl die Umsetzung zu einem Kondensationsprodukt (K) oder Polykondensationsprodukt (P) als auch die Reaktion von (K) oder (P) zu Polycarbonaten mit anderen funktionellen Gruppen oder Elementen kann in einer Reaktionsvorrichtung erfolgen, was technisch und wirtschaftlich vorteilhaft ist.

Als Komponente B2) enthalten die erfindungsgemäßen Formmassen mindestens eines hyperverzweigten Polyesters des Typs $A_xB_y$, wobei

x mindestens 1,1 vorzugsweise mindestens 1,3, insbesondere mindestens 2
y mindestens 2,1, vorzugsweise mindestens 2,5, insbesondere mindestens 3

beträgt.

Selbstverständlich können als Einheiten A bzw. B auch Mischungen eingesetzt werden.

Unter einem Polyester des Typs $A_xB_y$ versteht man ein Kondensat, das sich aus einem x-funktionellen Molekül A und einem y-funktionellen Molekül B aufbaut. Beispielsweise sei genannt ein Polyester aus Adipinsäure als Molekül A (x = 2) und Glycerin als Molekül B (y = 3).

Unter hyperverzweigten Polyestern B2) werden im Rahmen dieser Erfindung unvernetzte Makromoleküle mit Hydroxyl- und Carboxylgruppen verstanden, die sowohl strukturell als auch molekular uneinheitlich sind. Sie können auf der einen Seite ausgehend von einem Zentralmolekül analog zu Dendrimeren, jedoch mit uneinheitlicher Kettenlänge der Äste aufgebaut sein. Sie können auf der anderen Seite auch linear, mit funktionellen Seitengruppen, aufgebaut sein oder aber, als Kombination der beiden Extreme, lineare und verzweigte Molekülteile aufweisen. Zur Definition von dendrimeren und hyperverzweigten Polymeren siehe auch P.J. Flory, J. Am. Chem. Soc. 1952, 74, 2718 und H. Frey et al., Chem. Eur. J. 2000, 6, No. 14, 2499.

Unter "hyperverzweigt" wird im Zusammenhang mit der vorlegenden Erfindung verstanden, dass der Verzweigungsgrad (Degree of Branching, DB), dass heißt die mittlere Anzahl dendritischer Verknüpfungen plus mittlere Anzahl der Endgruppen pro Molekül, 10 bis 99.9 %, bevorzugt 20 bis 99 %, besonders bevorzugt 20 - 95 % beträgt.

Unter "dendrimer" wird im Zusammenhang mit der vorliegenden Erfindung verstanden, dass der Verzweigungsgrad 99,9 - 100% beträgt. Zur Definition des "Degree of Branching" siehe H. Frey et al., Acta Polym. 1997, 48, 30.

Die Komponente B2) weist vorzugsweise ein $M_n$ von 300 bis 30 000, insbesondere von 400 bis 25000 und ganz besonders von 500 bis 20000 g/mol auf, bestimmt mittels GPC, Standard PMMA, Laufmittel Dimethylacetamid.

Vorzugsweise weist B2) eine OH-Zahl von 0 bis 600, vorzugsweise 1 bis 500, insbesondere von 20 bis 500 mg KOH/g Polyester gemäß DIN 53240 auf sowie bevorzugt eine COOH-Zahl von 0 bis 600, vorzugsweise von 1 bis 500 und insbesondere von 2 bis 500 mg KOH/g Polyester.

Die $T_g$ beträgt vorzugsweise von -50°C bis 140°C und insbesondere von -50 bis 100°C (mittels DSC, nach DIN 53765).

Insbesondere solche Komponenten B2) sind bevorzugt, in denen mindestens eine OH- bzw. COOH-Zahl größer 0, vorzugsweise größer 0,1 und insbesondere größer 0,5 ist.

Insbesondere durch die nachfolgend beschriebenen Verfahren ist die erfindungsgemäße Komponente B2) erhältlich, u.z. indem man

(a) eine oder mehrere Dicarbonsäuren oder eines oder mehrere Derivate derselben mit einem oder mehreren mindestens trifunktionellen Alkoholen
oder

(b) eine oder mehrere Tricarbonsäuren oder höhere Polycarbonsäuren oder eines oder mehrere Derivate derselben mit einem oder mehreren Diolen

in Gegenwart eines Lösemittels und optional in Gegenwart eines anorganischen, metallorganischen oder niedermolekularen organischen Katalysators oder eines Enzyms umsetzt. Die Umsetzung im Lösungsmittel ist die bevorzugte Herstellmethode.

Hochfunktionelle hyperverzweigte Polyester B2) im Sinne der vorliegenden Erfindung sind molekular und strukturell uneinheitlich. Sie unterscheiden sich durch ihre molekulare Uneinheitlichkeit von Dendrimeren und sind daher mit erheblich geringerem Aufwand herzustellen.

Zu den nach Variante (a) umsetzbaren Dicarbonsäuren gehören beispielsweise Oxalsäure, Malonsäure, Bernsteinsäure, Glutarsäure, Adipinsäure, Pimelinsäure, Korksäure, Azelainsäure, Sebacinsäure, Undecan-a,w-dicarbonsäure, Dodecan-a,w-dicarbonsäure, cis- und trans-Cyclohexan-1,2-dicarbonsäure, cis- und trans-Cyclohexan-1,3-dicarbonsäure, cis- und trans-Cyclohexan-1,4-dicarbonsäure, cis- und trans-Cyclopentan-1,2-dicarbonsäure sowie cis- und trans-Cyclopentan-1,3-dicarbonsäure,
wobei die oben genannten Dicarbonsäuren substituiert sein können mit einem oder mehreren Resten, ausgewählt aus $C_1$-$C_{10}$-Alkylgruppen, beispielsweise Methyl, Ethyl, n-Propyl, iso-Propyl, n-Butyl, isoButyl, sec.-Butyl, tert.-Butyl, n-Pentyl, iso-Pentyl, sec.-Pentyl, neo-Pentyl, 1,2-Dimethylpropyl, iso-Amyl, n-Hexyl, iso-Hexyl, sec.-Hexyl, n-Heptyl, iso-Heptyl, n-Octyl, 2-Ethylhexyl, n-Nonyl oder n-Decyl,
$C_3$-$C_{12}$-Cycloalkylgruppen, beispielsweise Cyclopropyl, Cyclobutyl, Cyclopentyl, Cyclohexyl, Cycloheptyl, Cyclooctyl, Cyclononyl, Cyclodecyl, Cycloundecyl und Cyclododecyl; bevorzugt sind Cyclopentyl, Cyclohexyl und Cycloheptyl;
Alkylengruppen wie Methylen oder Ethyliden oder
$C_6$-$C_{14}$-Arylgruppen wie beispielsweise Phenyl, 1-Naphthyl, 2-Naphthyl, 1-Anthryl, 2-Anthryl, 9-Anthryl, 1-Phenanthryl, 2-Phenanthryl, 3-Phenanthryl, 4-Phenanthryl und 9-Phenanthryl, bevorzugt Phenyl, 1-Naphthyl und 2-Naphthyl, besonders bevorzugt Phenyl.

Als beispielhafte Vertreter für substituierte Dicarbonsäuren seien genannt: 2-Methylmalonsäure, 2-Ethylmalonsäure, 2-Phenylmalonsäure, 2-Methylbernsteinsäure, 2-Ethylbernsteinsäure, 2-Phenylbernsteinsäure, Itaconsäure, 3,3-Dimethylglutarsäure.

Weiterhin gehören zu den nach Variante (a) umsetzbaren Dicarbonsäuren ethylenisch ungesättigte Säuren wie beispielsweise Maleinsäure und Fumarsäure sowie aromatische Dicarbonsäuren wie beispielsweise Phthalsäure, Isophthalsäure oder Terephthalsäure.

Weiterhin lassen sich Gemische von zwei oder mehreren der vorgenannten Vertreter einsetzen.

Die Dicarbonsäuren lassen sich entweder als solche oder in Form von Derivaten einsetzen.

Unter Derivaten werden bevorzugt verstanden

- die betreffenden Anhydride in monomerer oder auch polymerer Form,
- Mono- oder Dialkylester, bevorzugt Mono- oder Dimethylester oder die entsprechenden Mono- oder Diethylester, aber auch die von höheren Alkoholen wie beispielsweise n-Propanol, iso-Propanol, n-Butanol, Isobutanol, tert.-Butanol, n-Pentanol, n-Hexanol abgeleiteten Mono- und Dialkylester,
- ferner Mono- und Divinylester sowie
- gemischte Ester, bevorzugt Methylethylester.

Im Rahmen der bevorzugten Herstellung ist es auch möglich, ein Gemisch aus einer Dicarbonsäure und einem oder mehreren ihrer Derivate einzusetzen. Gleichfalls ist es möglich, ein Gemisch mehrerer verschiedener Derivate von einer oder mehreren Dicarbonsäuren einzusetzen.

Besonders bevorzugt setzt man Bernsteinsäure, Glutarsäure, Adipinsäure, Phthalsäure, Isophthalsäure, Terephthalsäure oder deren Mono- oder Dimethylester ein. Ganz besonders bevorzugt setzt man Adipinsäure ein.

Als mindestens trifunktionelle Alkohole lassen sich beispielsweise umsetzen: Glycerin, Butan-1,2,4-triol, n-Pentan-1,2,5-triol, n-Pentan-1,3,5-triol, n-Hexan-1,2,6-triol, n-Hexan-1,2,5-triol, n-Hexan-1,3,6-triol, Trimethylolbutan, Trimethylolpropan oder Di-Trimethylolpropan, Trimethylolethan, Pentaerythrit oder Dipentaerythrit; Zuckeralkohole wie beispielsweise Mesoerythrit, Threitof, Sorbit, Mannit oder Gemische der vorstehenden mindestens trifunktionellen Alkohole. Bevorzugt verwendet man Glycerin, Trimethylolpropan, Trimethylolethan und Pentaerythrit.

Nach Variante (b) umsetzbare Tricarbonsäuren oder Polycarbonsäuren sind beispielsweise 1,2,4-Benzoltricarbonsäure, 1,3,5-Benzoltricarbonsäure, 1,2,4,5-Benzoltetracarbonsäure sowie Mellitsäure.

Tricarbonsäuren oder Polycarbonsäuren lassen sich in der erfindungsgemäßen Reaktion entweder als solche oder aber in Form von Derivaten einsetzen.

Unter Derivaten werden bevorzugt verstanden

- die betreffenden Anhydride in monomerer oder auch polymerer Form,

- Mono-, Di- oder Trialkylester, bevorzugt Mono-, Di- oder Trimethylester oder die entsprechenden Mono-, Di- oder Triethylester, aber auch die von höheren Alkoholen wie beispielsweise n-Propanol, iso-Propanol, n-Butanol, Isobutanol, tert.-Butanol, n-Pentanol, n-Hexanoi abgeleiteten Mono- Di- und Triester, ferner Mono-, Di- oder Trivinylester
- sowie gemischte Methylethylester.

Im Rahmen der vorliegenden Erfindung ist es auch möglich, ein Gemisch aus einer Tri- oder Polycarbonsäure und einem oder mehreren ihrer Derivate einzusetzen. Gleichfalls ist es im Rahmen der vorliegenden Erfindung möglich, ein Gemisch mehrerer verschiedener Derivate von einer oder mehreren Tri- oder Polycarbonsäuren einzusetzen, um Komponente B2) zu erhalten.

Als Diole für Variante (b) der vorliegenden Erfindung verwendet man beispielsweise Ethylenglykol, Propan-1,2-diol, Propan-1,3-diol, Butan-1,2-diol, Butan-1,3-diol, Butan-1,4-diol, Butan-2,3-diol, Pentan-1,2-diol, Pentan-1,3-diol, Pentan-1,4-diol, Pentan-1,5-diol, Pentan-2,3-diol, Pentan-2,4-diol, Hexan-1,2-diol, Hexan-1,3-diol, Hexan-1,4-diol, Hexan-1,5-diol, Hexan-1,6-diol, Hexan-2,5-diol, Heptan-1,2-diol 1,7-Heptandiol, 1,8-Octandiol, 1,2-Octandiol, 1,9-Nonandiol, 1,10-Decandiol, 1,2-Decandiol, 1,12-Dodecandiol, 1,2-Dodecandiol, 1,5-Hexadien-3,4-diol, Cyclopentandiole, Cyclohexandiole, Inositol und Derivate, (2)-Methyl-2,4-pentandiol, 2,4-Dimethyl-2,4-Pentandiol, 2-Ethyl-1,3-hexandiol, 2,5-Dimethyl-2,5-hexandiol, 2,2,4-Trimethyl-1,3-pentandiol, Pinacol, Diethylenglykol, Triethylenglykol, Dipropylenglykol, Tripropylenglykol, Polyethylenglykole $HO(CH_2CH_2O)_n$-H oder Polypropylenglykole $HO(CH[CH_3]CH_2O)_n$-H oder Gemische von zwei oder mehr Vertretern der voranstehenden Verbindungen, wobei n eine ganze Zahl ist und n = 4-25 beträgt. Dabei kann eine oder auch beide Hydroxylgruppen in den vorstehend genannten Diolen auch durch SH-Gruppen substituiert werden. Bevorzugt sind Ethylenglykol, Propan-1,2-diol sowie Diethylenglykol, Triethylenglykol, Dipropylenglykol und Tripropylenglykol.

Die Molverhältnis der Moleküle A zu Molekülen B im $A_x$ $B_y$-Polyester bei den Varianten (a) und (b) beträgt 4:1 bis 1:4, insbesondere 2:1 bis 1:2.

Die nach Variante (a) des Verfahrens umgesetzten mindestens trifunktionellen Alkohole können Hydroxylgruppen jeweils gleicher Reaktivität aufweisen. Bevorzugt sind hier auch mindestens trifunktionelle Alkohole, deren OH-Gruppen zunächst gleich reaktiv sind, bei denen sich jedoch durch Reaktion mit mindestens einer Säuregruppe ein Reaktivitätsabfall, bedingt durch sterische oder elektronische Einflüsse, bei den restlichen OH-Gruppen induzieren lässt. Dies ist beispielsweise bei der Verwendung von Trimethylolpropan oder Pentaerythrit der Fall.

Die nach Variante (a) umgesetzten mindestens trifunktionellen Alkohole können aber auch Hydroxylgruppen mit mindestens zwei chemisch unterschiedlichen Reaktivitäten aufweisen.

Die unterschiedliche Reaktivität der funktionellen Gruppen kann dabei entweder auf chemischen (z.B. primäre/sekundäre/tertiäre OH Gruppe) oder auf sterischen Ursachen beruhen.

Beispielsweise kann es sich bei dem Triol um ein Triol handeln, welches primäre und sekundäre Hydroxylgruppen aufweist, bevorzugtes Beispiel ist Glycerin.

Bei der Durchführung der erfindungsgemäßen Umsetzung nach Variante (a) arbeitet man bevorzugt in Abwesenheit von Diolen und monofunktionellen Alkoholen.

Bei der Durchführung der erfindungsgemäßen Umsetzung nach Variante (b) arbeitet man bevorzugt in Abwesenheit von mono- oder Dicarbonsäuren.

Das erfindungsgemäße Verfahren wird in Gegenwart eines Lösemittels durchgeführt. Geeignet sind beispielsweise Kohlenwasserstoffe wie Paraffine oder Aromaten. Besonders geeignete Paraffine sind n-Heptan und Cyclohexan. Besonders geeignete Aromaten sind Toluot, ortho-Xylol, meta-Xylol, para-Xylol, Xylol als Isomerengemisch, Ethylbenzol, Chlorbenzol und ortho- und meta-Dichlorbenzol. Weiterhin sind als Lösemittel in Abwesenheit von sauren Katalysatoren ganz besonders geeignet: Ether wie beispielsweise Dioxan oder Tetrahydrofuran und Ketone wie beispielsweise Methylethylketon und Methylisobutylketon.

Die Menge an zugesetztem Lösemittel beträgt erfindungsgemäß mindestens 0,1 Gew.-%, bezogen auf die Masse der eingesetzten umzusetzenden Ausgangsmaterialien, bevorzugt mindestens 1 Gew.-% und besonders bevorzugt mindestens 10 Gew.-%. Man kann auch Überschüsse an Lösemittel, bezogen auf die Masse an eingesetzten umzusetzenden Ausgangsmaterialien, einsetzen, beispielsweise das 1,01- bis 10-fache. Lösemittel-Mengen von mehr als dem 100-fachen, bezogen auf die Masse an eingesetzten umzusetzenden Ausgangsmaterialien, sind nicht vorteilhaft, weil bei deutlich niedrigeren Konzentrationen der Reaktionspartner die Reaktionsgeschwindigkeit deutlich nachlässt, was zu unwirtschaftlichen langen Umsetzungsdauern führt.

Zur Durchführung des erfindungsgemäß bevorzugten Verfahrens kann man in Gegenwart eines Wasser entziehenden Mittels als Additiv arbeiten, das man zu Beginn der Reaktion zusetzt. Geeignet sind beispielsweise Molekularsiebe, insbesondere Molekularsieb 4Å, $MgSO_4$ und $Na_2SO_4$. Man kann auch während der Reaktion weiteres Wasser entziehendes Mittel zufügen oder Wasser entziehendes Mittel durch frisches Wasser entziehendes Mittel ersetzen. Man kann auch während der Reaktion gebildetes Wasser bzw. Alkohol abdestillieren und beispielsweise einen Wasserabscheider einsetzen.

Man kann das Verfahren in Abwesenheit von sauren Katalysatoren durchführen. Vorzugsweise arbeitet man in Gegenwart eines sauren anorganischen, metallorganischen oder organischen Katalysators oder Gemischen aus mehreren sauren anorganischen, metallorganischen oder organischen Katalysatoren.

Als saure anorganische Katalysatoren im Sinne der vorliegenden Erfindung sind beispielsweise Schwefelsäure, Phosphorsäure, Phosphonsäure, hypophosphorige Säure, Aluminiumsulfathydrat, Alaun, saures Kieselgel (pH = 6, insbesondere = 5) und saures Aluminiumoxid zu nennen. Weiterhin sind beispielsweise Alumiumverbindungen der allgemeinen Formel $Al(OR)_3$ und Titanate der allgemeinen Formel $Ti(OR)_4$ als saure anorganische Katalysatoren einsetzbar, wobei die Reste R jeweils gleich oder verschieden sein können und unabhängig voneinander gewählt sind aus $C_1$-$C_{10}$-Alkylresten, beispielsweise Methyl, Ethyl, n-Propyl, iso-Propyl, n-Butyl, isoButyl, sec.-Butyl, tert.-Butyl, n-Pentyl, iso-Pentyl, sec.-Pentyl, neo-Pentyl, 1,2-Dimethylpropyl, iso-Amyl, n-Hexyl, iso-Hexyl, sec.-Hexyl, n-Heptyl, iso-Heptyl, n-Octyl, 2-Ethylhexyl, n-Nonyl oder n-Decyl,

$C_3$-$C_{12}$-Cycloalkylresten, beispielsweise Cyclopropyl, Cyclobutyl, Cyclopentyl, Cyclohexyl, Cycloheptyl, Cyclooctyl, Cyclononyl, Cyclodecyl, Cycloundecyl und Cyclododecyl; bevorzugt sind Cyclopentyl, Cyclohexyl und Cycloheptyl.

Bevorzugt sind die Reste R in $Al(OR)_3$ bzw. $Ti(OR)_4$ jeweils gleich und gewählt aus Isopropyl oder 2-Ethylhexyl.

Bevorzugte saure metallorganische Katalysatoren sind beispielsweise gewählt aus Dialkylzinnoxiden $R_2SnO$, wobei R wie oben stehend definiert ist. Ein besonders bevorzugter Vertreter für saure metallorganische Katalysatoren ist Di-n-butylzinnoxid, das als sogenanntes Oxo-Zinn kommerziell erhältlich ist, oder Di-n-butylzinndilaurat.

Bevorzugte saure organische Katalysatoren sind saure organische Verbindungen mit beispielsweise Phosphatgruppen, Sulfonsäuregruppen, Sulfatgruppen oder Phosphonsäuregruppen. Besonders bevorzugt sind Sulfonsäuren wie beispielsweise para-Toluolsulfonsäure. Man kann auch saure Ionentauscher als saure organische Katalysatoren einsetzen, beispielsweise Sulfonsäuregruppen-haltige Polystyrolharze, die mit etwa 2 mol-% Divinylbenzol vernetzt sind.

Man kann auch Kombinationen von zwei oder mehreren der vorgenannten Katalysatoren einsetzen. Auch ist es möglich, solche organische oder metallorganische oder auch anorganische Katalysatoren, die in Form diskreter Moleküle vorliegen, in immobilisierter Form einzusetzen.

Wünscht man saure anorganische, metallorganische oder organische Katalysatoren einzusetzen, so setzt man erfindungsgemäß 0,1 bis 10 Gew.-%, bevorzugt 0,2 bis 2 Gew.-% Katalysator ein.

Das erfindungsgemäße Verfahren wird unter Inertgasatmosphäre durchgeführt, das heißt beispielsweise unter Kohlendioxid, Stickstoff oder Edelgas, unter denen insbesondere Argon zu nennen ist.

Das erfindungsgemäße Verfahren wird bei Temperaturen von 60 bis 200°C durchgeführt. Vorzugsweise arbeitet man bei Temperaturen von 130 bis 180, insbesondere bis 150°C oder darunter. Besonders bevorzugt sind maximale Temperaturen bis 145°C, ganz besonders bevorzugt bis 135°C.

Die Druckbedingungen des erfindungsgemäßen Verfahrens sind an sich unkritisch. Man kann bei deutlich verringertem Druck arbeiten, beispielsweise bei 10 bis 500 mbar. Das erfindungsgemäße Verfahren kann auch bei Drucken oberhalb von 500 mbar durchgeführt werden. Bevorzugt ist aus Gründen der Einfachheit die Umsetzung bei Atmosphärendruck; möglich ist aber auch eine Durchführung bei leicht erhöhtem Druck, beispielsweise bis 1200 mbar. Man kann auch unter deutlich erhöhtem Druck arbeiten, beispielsweise bei Drucken bis 10 bar. Bevorzugt ist die Umsetzung bei Atmosphärendruck.

Die Umsetzungsdauer des erfindungsgemäßen Verfahrens beträgt üblicherweise 10 Minuten bis 25 Stunden, bevorzugt 30 Minuten bis 10 Stunden und besonders bevorzugt eine bis 8 Stunden.

Nach beendeter Reaktion lassen sich die hochfunktionellen hyperverzweigten Polyester leicht isolieren, beispielsweise durch Abfiltrieren des Katalysators und Einengen, wobei man das Einengen üblicherweise bei vermindertem Druck durchführt. Weitere gut geeignete Aufarbeitungsmethoden sind Ausfällen nach Zugabe von Wasser und anschließendes Waschen und Trocknen.

Weiterhin kann die Komponente B2) in Gegenwart von Enzymen oder Zersetzungsprodukten von Enzymen hergestellt werden (gemäß DE-A 101 63163). Es gehören die erfindungsgemäß umgesetzten Dicarbonsäuren nicht zu den sauren organischen Katalysatoren im Sinne der vorliegenden Erfindung.

Bevorzugt ist die Verwendung von Lipasen oder Esterasen. Gut geeignete Lipasen und Esterasen sind Candida cylindracea, Candida lipolytica, Candida rugosa, Candida antarctica, Candida utilis, Chromobacterium viscosum, Geolrichum viscosum, Geotrichum candidum, Mucor javanicus, Mucor mihei, pig pancreas, pseudomonas spp., pseudomonas fluorescens, Pseudomonas cepacia, Rhizopus arrhizus, Rhizopus delemar, Rhizopus niveus, Rhizopus oryzae, Aspergillus niger, Penicillium roquefortii, Penicillium camembertii oder Esterase von Bacillus spp. und Bacillus thermoglucosidasius. Besonders bevorzugt ist Candida antarctica Lipase B. Die aufgeführten Enzyme sind kommerziell erhältlich, beispielsweise bei Novozymes Biotech Inc., Dänemark.

Bevorzugt setzt man das Enzym in immobilisierter Form ein, beispielsweise auf Kieselgel oder Lewatit®. Verfahren zur Immobilisierung von Enzymen sind an sich bekannt, beispielsweise aus Kurt Faber, "Biotransformations in organic chemistry", 3. Auflage 1997, Springer Verlag, Kapitel 3.2 "Immobilization" Seite 345-356. Immobilisierte Enzyme sind kommerziell erhältlich, beispielsweise bei Novozymes Biotech Inc., Dänemark.

Die Menge an immobilisiertem eingesetztem Enzym beträgt 0,1 bis 20 Gew.-%, insbesondere 10 bis 15 Gew.-%, bezogen auf die Masse der insgesamt eingesetzten umzusetzenden Ausgangsmaterialien.

Das erfindungsgemäße Verfahren wird bei Temperaturen über 60°C durchgeführt. Vorzugsweise arbeitet man bei Temperaturen von 100°C oder darunter. Bevorzugt sind Temperaturen bis 80°C, ganz besonders bevorzugt von 62 bis 75°C und noch mehr bevorzugt von 65 bis 75°C.

Das erfindungsgemäße Verfahren wird in Gegenwart eines Lösemittels durchgeführt. Geeignet sind beispielsweise Kohlenwasserstoffe wie Paraffine oder Aromaten. Besonders geeignete Paraffine sind n-Heptan und Cyclohexan. Besonders geeignete Aromaten sind Toluol, ortho-Xylol, meta-Xylol, para-Xylol, Xylol als Isomerengemisch, Ethylbenzol, Chlorbenzol und ortho- und meta-Dichlorbenzol. Weiterhin sind ganz besonders geeignet: Ether wie beispielsweise Dioxan oder Tetrahydrofuran und Ketone wie beispielsweise Methylethylketon und Methylisobutylketon.

Die Menge an zugesetztem Lösemittel beträgt mindestens 5 Gew.-Teile, bezogen auf die Masse der eingesetzten umzusetzenden Ausgangsmaterialien, bevorzugt mindestens 50 Gew.-Teile und besonders bevorzugt mindestens 100 Gew.-Teile. Mengen von über 10 000 Gew.-Teile Lösemittel sind nicht erwünscht, weil bei deutlich niedrigeren Konzentrationen die Reaktionsgeschwindigkeit deutlich nachlässt, was zu unwirtschaftlichen langen Umsetzungsdauern führt.

Das erfindungsgemäße Verfahren wird bei Drücken oberhalb von 500 mbar durchgeführt. Bevorzugt ist die Umsetzung bei Atmosphärendruck oder leicht erhöhtem Druck, beispielsweise bis 1200 mbar. Man kann auch unter deutlich erhöhtem Druck arbeiten, beispielsweise bei Drücken bis 10 bar. Bevorzugt ist die Umsetzung bei Atmosphärendruck.

Die Umsetzungsdauer des erfindungsgemäßen Verfahrens beträgt üblicherweise 4 Stunden bis 6 Tage, bevorzugt 5 Stunden bis 5 Tage und besonders bevorzugt 8 Stunden bis 4 Tage.

Nach beendeter Reaktion lassen sich die hochfunktionellen hyperverzweigten Polyester isolieren, beispielsweise durch Abfiltrieren des Enzyms und Einengen, wobei man das Einengen üblicherweise bei vermindertem Druck durchführt. Weitere gut geeignete Aufarbeitungsmethoden sind Ausfällen nach Zugabe von Wasser und anschließendes Waschen und Trocknen.

Die nach dem erfindungsgemäßen Verfahren erhältlichen hochfunktionellen, hyperverzweigten Polyester, zeichnen sich durch besonders geringe Anteile an Verfärbungen und Verharzungen aus. Zur Definition von hyperverzweigten Polymeren siehe auch: P.J. Flory, J. Am. Chem. Soc. 1952, 74, 2718 und A. Sunder et al., Chem. Eur. J. 2000, 6, No.1, 1-8. Unter "hochfunktionell hyperverzweigt" wird im Zusammenhang mit der vorliegenden Erfindung jedoch verstanden, dass der Verzweigungsgrad (Degree of branching), das heißt die mittlere Anzahl von dendritischen Verknüpfungen plus die mittlere Anzahl von Endgruppen pro Molekül 10 - 99,9 %, bevorzugt 20 - 99 %, besonders bevorzugt 30 - 90 % beträgt (siehe dazu H. Frey et al. Acta Polym. 1997, 48, 30).

Die erfindungsgemäßen Polyester haben ein Molekulargewicht $M_w$ von 500 bis 50 000 g/mol, bevorzugt 1000 bis 20 000, besonders bevorzugt 1000 bis 19 000. Die Polydispersität beträgt 1,2 bis 50, bevorzugt 1,4 bis 40, besonders bevorzugt 1,5 bis 30 und ganz besonders bevorzugt 1,5 bis 10. Sie sind üblicherweise gut löslich, d.h. man kann klare Lösungen mit bis zu 50 Gew.-%, in einigen Fällen sogar bis zu 80 Gew.-%, der erfindungsgemäßen Polyester in Tetrahydrofuran (THF), n-Butylacetat, Ethanol und zahlreichen anderen Lösemitteln darstellen, ohne dass mit bloßem Auge Gelpartikel detektierbar sind.

Die erfindungsgemäßen hochfunktionellen hyperverzweigten Polyester sind carboxyterminiert, carboxy- und Hydroxylgruppen-terminiert und vorzugsweise Hydroxylgruppen-terminiert.

Die Verhältnisse der Komponenten B1) zu B2) betragen vorzugsweise von 1 : 20 bis 20 : 1; insbesondere von 1 : 15 bis 15 : 1 und ganz besonders von 1 : 5 bis 5 : 1.

Die eingesetzten hyperverzweigten Polycarbonate B1) / Polyester B2) liegen im Polymerblend fein verteilt vor, die Größe der Partikel im Compound beträgt von 20 bis 500 nm, vorzugsweise 50 - 300 nm.
Derartige Compounds sind im Handel als Ultradur® high speed erhältlich.

Als Komponente C) können die erfindungsgemäßen Formmassen 0 bis 60, insbesondere bis zu 50 Gew.- % weiterer Zusatzstoffe und Verarbeitungshilfsmittel enthalten, welche verschieden von B) sind.

Als Komponente C) können die erfindungsgemäßen Formmassen 0 bis 5, vorzugsweise 0,05 bis 3 und insbesondere 0,1 bis 2 Gew.-% mindestens eines Esters oder Amids gesättigter oder ungesättigter aliphatischer Carbonsäuren mit 10 bis 40, bevorzugt 16 bis 22 C-Atomen mit aliphatischen gesättigten Alkoholen oder Aminen mit 2 bis 40, vorzugsweise 2 bis 6 C-Atomen enthalten.

Die Carbonsäuren können 1- oder 2-wertig sein. Als Beispiele seien Pelargonsäure, Palmitinsäure, Laurinsäure, Margarinsäure, Dodecandisäure, Behensäure und besonders bevorzugt Stearinsäure, Caprinsäure sowie Montansäure (Mischung von Fettsäuren mit 30 bis 40 C-Atomen) genannt.

Die aliphatischen Alkohole können 1- bis 4-wertig sein. Beispiele für Alkohole sind n-Butanol, n-Octanol, Stearylalkohol, Ethylenglykol, Propylenglykol, Neopentylglykol, Pentaerythrit, wobei Glycerin und Pentaerythrit bevorzugt sind.

Die aliphatischen Amine können 1- bis 3-wertig sein. Beispiele hierfür sind Stearylamin, Ethylendiamin, Propylendiamin, Hexamethylendiamin, Di(6-Aminohexyl)amin, wobei Ethylendiamin und Hexamethylendiamin besonders bevorzugt sind. Bevorzugte Ester oder Amide sind entsprechend Glycerindistearat, Glycerintristearat, Ethylendiamindistearat, Glycerinmonopalmitrat, Glycerintrilaurat, Glycerinmonobehenat und Pentaerythrittetrastearat.

Es können auch Mischungen verschiedener Ester oder Amide oder Ester mit Amiden in Kombination eingesetzt werden, wobei das Mischungsverhältnis beliebig ist.

Weitere übliche Zusatzstoffe C) sind beispielsweise in Mengen bis zu 40, vorzugsweise bis zu 30 Gew.-% kautschukelastische Polymerisate (oft auch als Schlagzähmodifier, Elastomere oder Kautschuke bezeichnet).

Ganz allgemein handelt es sich dabei um Copolymerisate die bevorzugt aus mindestens zwei der folgenden Monomeren aufgebaut sind: Ethylen, Propylen, Butadien, Isobuten, Isopren, Chloropren, Vinylacetat, Styrol, Acrylnitril und Acryl- bzw. Methacrylsäureester mit 1 bis 18 C-Atomen in der Alkoholkomponente.

Derartige Polymere werden z.B. in Houben-Weyl, Methoden der organischen Chemie, Bd. 14/1 (Georg-Thieme-Verlag, Stuttgart, 1961). Seiten 392 bis 406 und in der Monographie von C.B. Bucknall, "Toughened Plastics" (Applied Science Publishers, London, 1977) beschrieben.

Im folgenden werden einige bevorzugte Arten solcher Elastomerer vorgestellt.

Bevorzugte Arten von solchen Elastomeren sind die sog. Ethylen-Propylen (EPM) bzw. Ethylen-Propylen-Dien-(EPDM)-Kautschuke.

EPM-Kautschuke haben im allgemeinen praktisch keine Doppelbindungen mehr, während EPDM-Kautschuke 1 bis 20 Doppelbindungen/100 C-Atome aufweisen können.

Als Dien-Monomere für EPDM-Kautschuke seien beispielsweise konjugierte Diene wie Isopren und Butadien, nicht-konjugierte Diene mit 5 bis 25 C-Atomen wie Penta-1,4-dien, Hexa-1,4-dien, Hexa-1,5-dien, 2,5-Dimethylhexa-1,5-dien und Octa-1,4-dien, cyclische Diene wie Cyclopentadien, Cyclohexadiene, Cyclooctadiene und Dicyclopentadien sowie Alkenylnorbornene wie 5-Ethyliden-2-norbornen, 5-Butyliden-2-norbomen, 2-Methallyl-5-norbomen, 2-Isopropenyl-5-norbornen und Tricyclodiene wie 3-Methyltricyclo(5.2.1.0.2.6)-3,8-decadien oder deren Mischungen genannt. Bevorzugt werden Hexa-1,5-dien, 5-Ethylidennorbornen und Dicyclopentadien. Der Diengehalt der EPDM-Kautschuke beträgt vorzugsweise 0,5 bis 50, insbesondere 1 bis 8 Gew.-%, bezogen auf das Gesamtgewicht des Kautschuks.

EPM- bzw. EPDM-Kautschuke können vorzugsweise auch mit reaktiven Carbonsäuren oder deren Derivaten gepfropft sein. Hier seien z.B. Acrylsäure, Methacrylsäure und deren Derivate, z.B. Glycidyl(meth)acrylat, sowie Maleinsäureanhydrid genannt.

Eine weitere Gruppe bevorzugter Kautschuke sind Copolymere des Ethylens mit Acrylsäure und/oder Methacrylsäure und/oder den Estern dieser Säuren. Zusätzlich können die Kautschuke noch Dicarbonsäuren wie Maleinsäure und Fumarsäure oder Derivate dieser Säuren, z.B. Ester und Anhydride, und/oder Epoxy-Gruppen enthaltende Monomere enthalten. Diese Dicarbonsäurederivate bzw. Epoxygruppen enthaltende Monomere werden vorzugsweise durch Zugabe von Dicarbonsäure- bzw. Epoxygruppen enthaltenden Monomeren der allgemeinen Formeln I oder II oder III oder IV zum Monomerengemisch in den Kautschuk eingebaut

$$R^1C(COOR^2)=C(COOR^3)R^4 \qquad (I)$$

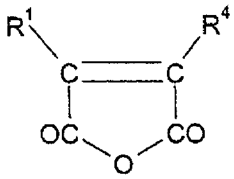

(II)

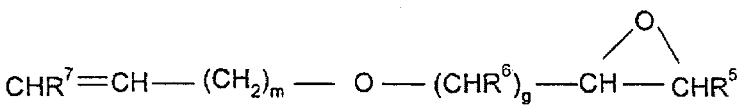

(III)

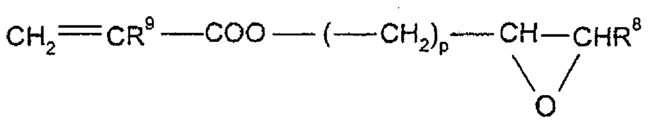

(IV)

wobei $R^1$ bis $R^9$ Wasserstoff oder Alkylgruppen mit 1 bis 6 C-Atomen darstellen und m eine ganze Zahl von 0 bis 20, g eine ganze Zahl von 0 bis 10 und p eine ganze Zahl von 0 bis 5 ist

Vorzugsweise bedeuten die Reste $R^1$ bis $R^9$ Wasserstoff, wobei m für 0 oder 1 und g für 1 steht. Die entsprechenden Verbindungen sind Maleinsäure, Fumarsäure, Maleinsäureanhydrid, Allylglycidylether und Vinylglycidylether.

Bevorzugte Verbindungen der Formeln I, II und IV sind Maleinsäure, Maleinsäureanhydrid und Epoxygruppen-enthaltende Ester der Acrylsäure und/oder Methacrylsäure, wie Glycidylacrylat, Glycidylmethacrylat und die Ester mit tertiären Alkoholen, wie t-Butylacrylat. Letztere weisen zwar keine freien Carboxylgruppen auf, kommen in ihrem Verhalten aber den freien Säuren nahe und werden deshalb als Monomere mit latenten Carboxylgruppen bezeichnet.

Vorteilhaft bestehen die Copolymeren aus 50 bis 98 Gew.-% Ethylen, 0,1 bis 20 Gew.-% Epoxygruppen enthaltenden Monomeren und/oder Methacrylsäure und/oder Säureanhydridgruppen enthaltenden Monomeren sowie der restlichen Menge an (Meth)acrylsäureestern.

Besonders bevorzugt sind Copolymerisate aus

50 bis 98, insbesondere 55 bis 95 Gew.-% Ethylen,

0,1 bis 40, insbesondere 0,3 bis 20 Gew.-% Glycidylacrylat und/oder Glycidylmethacrylat, (Meth)acrylsäure und/oder Maleinsäureanhydrid, und

1 bis 45, insbesondere 10 bis 40 Gew.-% n-Butylacrylat und/oder 2-Ethylhexylacrylat.

Weitere bevorzugte Ester der Acryl- und/oder Methacrylsäure sind die Methyl-, Ethyl-, Propyl- und i- bzw. t-Butylester.

Daneben können auch Vinylester und Vinylether als Comonomere eingesetzt werden.

Die vorstehend beschriebenen Ethylencopolymeren können nach an sich bekannten Verfahren hergestellt werden, vorzugsweise durch statistische Copolymerisation unter hohem Druck und erhöhter Temperatur. Entsprechende Verfahren sind allgemein bekannt.

Bevorzugte Elastomere sind auch Emulsionspolymerisate, deren Herstellung z.B. bei Blackley in der Monographie "Emulsion Polymerization" beschrieben wird. Die verwendbaren Emulgatoren und Katalysatoren sind an sich bekannt.

Grundsätzlich können homogen aufgebaute Elastomere oder aber solche mit einem Schalenaufbau eingesetzt werden. Der schalenartige Aufbau wird durch die Zugabereihenfolge der einzelnen Monomeren bestimmt; auch die Morphologie der Polymeren wird von dieser Zugabereihenfolge beeinflusst.

Nur stellvertretend seien hier als Monomere für die Herstellung des Kautschukteils der Elastomeren Acrylate wie z.B. n-Butylacrylat und 2-Ethylhexylacrylat, entsprechende Methacrylate, Butadien und Isopren sowie deren Mischungen genannt. Diese Monomeren können mit weiteren Monomeren wie z.B. Styrol, Acrylnitril, Vinylethern und weiteren Acrylaten oder Methacrylaten wie Methylmethacrylat, Methylacrylat, Ethylacrylat und Propylacrylat copolymerisiert werden.

Die Weich- oder Kautschukphase (mit einer Glasübergangstemperatur von unter 0°C) der Elastomeren kann den Kern, die äußere Hülle oder eine mittlere Schale (bei Elastomeren mit mehr als zweischaligem Aufbau) darstellen; bei mehrschaligen Elastomeren können auch mehrere Schalen aus einer Kautschukphase bestehen.

Sind neben der Kautschukphase noch eine oder mehrere Hartkomponenten (mit Glasübergangstemperaturen von mehr als 20°C) am Aufbau des Elastomeren beteiligt, so werden diese im allgemeinen durch Polymerisation von Styrol, Acrylnitril, Methacrylnitril, $\alpha$-Methylstyrol, p-Methylstyrol, Acrylsäureestern und Methacrylsäureestern wie Methylacrylat, Ethylacrylat und Methylmethacrylat als Hauptmonomeren hergestellt. Daneben können auch hier geringere Anteile an weiteren Comonomeren eingesetzt werden.

In einigen Fällen hat es sich als vorteilhaft herausgestellt, Emulsionspolymerisate einzusetzen, die an der Oberfläche reaktive Gruppen aufweisen. Derartige Gruppen sind z.B. Epoxy-, Carboxyl-, latente Carboxyl-, Amino- oder Amidgruppen sowie funktionelle Gruppen, die durch Mitverwendung von Monomeren der allgemeinen Formel

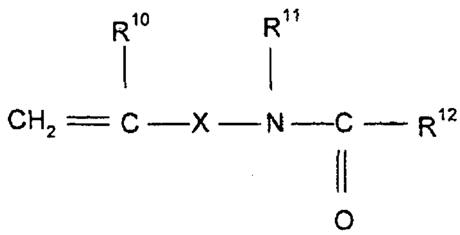

eingeführt werden können,
wobei die Substituenten folgende Bedeutung haben können:

$R^{10}$ Wasserstoff oder eine $C_1$- bis $C_4$-Alkylgruppe,

$R^{11}$ Wasserstoff, eine $C_1$- bis $C_8$-Alkylgruppe oder eine Arylgruppe, insbesondere Phenyl,

$R^{12}$ Wasserstoff, eine $C_1$- bis $C_{10}$-Alkyl-, eine $C_6$- bis $C_{12}$-Arylgruppe oder $-OR^{13}$

$R^{13}$ eine $C_1$- bis $C_8$-Alkyl- oder $C_6$- bis $C_{12}$-Arylgruppe, die gegebenenfalls mit O- oder N-haltigen Gruppen substituiert sein können,

X eine chemische Bindung, eine $C_1$- bis $C_{10}$-Alkylen- oder $C_6$-$C_{12}$-Arylengruppe oder

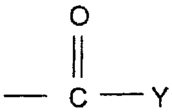

Y O-Z oder NH-Z und

Z eine $C_1$- bis $C_{10}$-Alkylen- oder $C_6$- bis $C_{12}$-Arylengruppe.

Auch die in der EP-A 208 187 beschriebenen Pfropfmonomeren sind zur Einführung reaktiver Gruppen an der Oberfläche geeignet.

Als weitere Beispiele seien noch Acrylamid, Methacrylamid und substituierte Ester der Acrylsäure oder Methacrylsäure wie (N-t-Butylamino)-ethylmethacrylat, (N,N-Dimethyl-amino)ethylacrylat, (N,N-Dimethylamino)-methylacrylat und (N,N-Diethylamino)ethyl-acrylat genannt.

Weiterhin können die Teilchen der Kautschukphase auch vernetzt sein. Als Vernetzer wirkende Monomere sind beispielsweise Buta-1,3-dien, Divinylbenzol, Diallylphthalat und Dihydrodicyclopentadienylacrylat sowie die in der EP-A 50 265 beschriebenen Verbindungen.

Ferner können auch sogenannten pfropfvernetzende Monomere (graft-linking monomers) verwendet werden, d.h. Monomere mit zwei oder mehr polymerisierbaren Doppelbindungen, die bei der Polymerisation mit unterschiedlichen Geschwindigkeiten reagieren. Vorzugsweise werden solche Verbindungen verwendet, in denen mindestens eine reaktive Gruppe mit etwa gleicher Geschwindigkeit wie die übrigen Monomeren polymerisiert, während die andere reaktive Gruppe (oder reaktive Gruppen) z.B. deutlich langsamer polymerisiert (polymerisieren). Die unterschiedlichen Polymerisationsgeschwindigkeiten bringen einen bestimmten Anteil an ungesättigten Doppelbindungen im Kautschuk mit sich. Wird anschließend auf einen solchen Kautschuk eine weitere Phase aufgepfropft, so reagieren die im Kautschuk vorhandenen Doppelbindungen zumindest teilweise mit den Pfropfmonomeren unter Ausbildung von chemischen Bindungen, d.h. die aufgepfropfte Phase ist zumindest teilweise über chemische Bindungen mit der Pfropfgrundlage verknüpft.

Beispiele für solche pfropfvernetzende Monomere sind Allylgruppen enthaltende Monomere, insbesondere Allylester von ethylenisch ungesättigten Carbonsäuren wie Allylacrylat, Allylmethacrylat, Diallylmaleat, Diallylfumarat, Diallylitaconat oder die entsprechenden Monoallylverbindungen dieser Dicarbonsäuren. Daneben gibt es eine Vielzahl weiterer geeigneter pfropfvernetzender Monomerer; für nähere Einzelheiten sei hier beispielsweise auf die US-PS 4 148 846 verwiesen.

Im allgemeinen beträgt der Anteil dieser vernetzenden Monomeren an dem schlagzäh modifizierenden Polymer bis zu 5 Gew.-%, vorzugsweise nicht mehr als 3 Gew.-%, bezogen auf das schlagzäh modifizierende Polymere.

Nachfolgend seien einige bevorzugte Emulsionspolymerisate aufgeführt. Zunächst sind hier Pfropfpolymerisate mit einem Kern und mindestens einer äußeren Schale zu nennen, die folgenden Aufbau haben:

| Typ | Monomere für den Kern | Monomere für die Hülle |
|---|---|---|
| I | Buta-1,3-dien, Isopren, n-Butylacrylat, Ethylhexylacrylat oder deren Mischungen | Styrol, Acrylnitril, Methylmethacrylat |
| II | wie I aber unter Mitverwendung von Vernetzern | wie I |
| III | wie I oder II | n-Butylacrylat, Ethylacrylat, Methylacrylat, Buta-1,3-dien, Isopren, Ethylhexylacrylat |
| IV | wie I oder II | wie I oder III aber unter Mitverwendung von Monomeren mit reaktiven Gruppen wie hierin beschrieben |

(fortgesetzt)

| Typ | Monomere für den Kern | Monomere für die Hülle |
|---|---|---|
| V | Styrol, Acrylnitril, Methylmethacrylat oder deren Mischungen | erste Hülle aus Monomeren wie unter I und II für den Kern beschrieben<br>zweite Hülle wie unter I oder IV für die Hülle beschrieben |

Diese Pfropfpolymerisate, insbesondere ABS- und/oder ASA-Polymere in Mengen bis zu 40 Gew.-%, werden vorzugsweise zur Schlagzähmodifizierung von PBT, gegebenenfalls in Mischung mit bis zu 40 Gew.-% Polyethylenterephthalat eingesetzt. Entsprechende Blend-Produkte sind unter dem Warenzeichen Ultradur®S (ehemals Ultrablend®S der BASF AG) erhältlich.

Anstelle von Pfropfpolymerisaten mit einem mehrschaligen Aufbau können auch homogene, d.h. einschalige Elastomere aus Buta-1,3-dien, Isopren und n-butylacrylat oder deren Copolymeren eingesetzt werden. Auch diese Produkte können durch Mitverwendung von vernetzenden Monomeren oder Monomeren mit reaktiven Gruppen hergestellt werden.

Beispiele für bevorzugte Emulsionspolymerisate sind n-Butylacrylat/(Meth)acrylsäure-Copolymere, n-Butylacrylat/Glycidylacrylat- oder n-Butylacrylat/Glycidylmethacrylat-Copolymere, Pfropfpolymerisate mit einem inneren Kern aus n-Butylacrylat oder auf Butadienbasis und einer äußeren Hülle aus den vorstehend genannten Copolymeren und Copolymere von Ethylen mit Comonomeren, die reaktive Gruppen liefern.

Die beschriebenen Elastomere können auch nach anderen üblichen Verfahren, z.B. durch Suspensionspolymerisation, hergestellt werden.

Siliconkautschuke, wie in der DE-A 37 25 576, der EP-A 235 690, der DE-A 38 00 603 und der EP-A 319 290 beschrieben, sind ebenfalls bevorzugt.

Selbstverständlich können auch Mischungen der vorstehend aufgeführten Kautschuktypen eingesetzt werden.

Als faser- oder teilchenförmige Füllstoffe C) seien Kohlenstofffasern, Glasfasern, Glaskugeln, amorphe Kieselsäure, Asbest, Calciumsilicat, Calciummetasilicat, Magnesium-carbonat, Kaolin, Kreide, gepulverter Quarz, Glimmer, Bariumsulfat und Feldspat genannt, die in Mengen bis zu 50 Gew.-%, insbesondere bis zu 40 % eingesetzt werden.

Als bevorzugte faserförmige Füllstoffe seien Kohlenstofffasern, Aramid-Fasem und Kaliumtitanat-Fasern genannt, wobei Glasfasern als E-Glas besonders bevorzugt sind. Diese können als Rovings oder Schnittglas in den handelsüblichen Formen eingesetzt werden.

Mischungen von Glasfasern C) mit Komponente B) im Verhältnis von 1 : 100 bis 1 : 2 und bevorzugt von 1 : 10 bis 1 : 3 sind insbesondere bevorzugt.

Die faserförmigen Füllstoffe können zur besseren Verträglichkeit mit dem Thermoplasten mit einer Silanverbindung oberflächlich vorbehandelt sein.

Geeignete Silanverbindungen sind solche der allgemeinen Formel

$$(X\text{-}(CH_2)_n)_k\text{-}Si\text{-}(O\text{-}C_mH_{2m+1})_{4\text{-}k}$$

in der die Substituenten folgende Bedeutung haben:

X $NH_2$-.

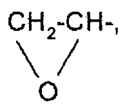 HO-,

n eine ganze Zahl von 2 bis 10, bevorzugt 3 bis 4

m eine ganze Zahl von 1 bis 5, bevorzugt 1 bis 2

k eine ganze Zahl von 1 bis 3, bevorzugt 1

Bevorzugte Silanverbindungen sind Aminopropyltrimethoxysilan, Aminobutyltrimethoxysilan, Aminopropyltriethoxysilan, Aminobutyltriethoxysilan sowie die entsprechenden Silane, welche als Substituent X eine Glycidylgruppe enthalten.

Die Silanverbindungen werden im allgemeinen in Mengen von 0,05 bis 5, vorzugsweise 0,5 bis 1,5 und insbesondere 0,8 bis 1 Gew.-% (bezogen auf C) zur Oberflächenbeschichtung eingesetzt.

Geeignet sind auch nadelförmige mineralische Füllstoffe.

Unter nadelförmigen mineralischen Füllstoffen wird im Sinne der Erfindung ein mineralischer Füllstoff mit stark ausgeprägtem nadelförmigen Charakter verstanden. Als Beispiel sei nadelförmiger Wollastonit genannt. Vorzugsweise weist das Mineral ein L/D-(Länge Durchmesser)-Verhältnis von 8 : 1 bis 35 : 1, bevorzugt von 8 : 1 bis 11 : 1 auf. Der mineralische Füllstoff kann gegebenenfalls mit den vorstehend genannten Silanverbindungen vorbehandelt sein; die Vorbehandlung ist jedoch nicht unbedingt erforderlich.

Als weitere Füllstoffe seien Kaolin, calciniertes Kaolin, Wollastonit, Talkum und Kreide genannt.

Als Komponente C) können die erfindungsgemäßen thermoplastischen Formmassen übliche Verarbeitungshilfsmittel wie Stabilisatoren, Oxidationsverzögerer, Mittel gegen Wärmezersetzung und Zersetzung durch ultraviolettes Licht, Gleit- und Entformungsmittel, Färbemittel wie Farbstoffe und Pigmente, Keimbildungsmittel, Weichmacher usw. enthalten.

Als Beispiele für Oxidationsverzögerer und Wärmestabilisatoren sind sterisch gehinderte Phenole und/oder Phosphite, Hydrochinone, aromatische sekundäre Amine wie Diphenylamine, verschiedene substituierte Vertreter dieser Gruppen und deren Mischungen in Konzentrationen bis zu 1 Gew.-%, bezogen auf das Gewicht der thermoplastischen Formmassen genannt.

Als UV-Stabilisatoren, die im allgemeinen in Mengen bis zu 2 Gew.-%, bezogen auf die Formmasse, verwendet werden, seien verschiedene substituierte Resorcine, Salicylate, Benzotriazole und Benzophenone genannt.

Es können anorganische Pigmente, wie Titandioxid, Ultramarinblau, Eisenoxid und Ruß, weiterhin organische Pigmente, wie Phthalocyanine, Chinacridone, Perylene sowie Farbstoffe, wie Nigrosin und Anthrachinone als Farbmittel zugesetzt werden.

Als Keimbildungsmittel können Natriumphenylphosphinat, Aluminiumoxid, Siliziumdioxid sowie bevorzugt Talkum eingesetzt werden.

Weitere Gleit- und Entformungsmittel werden üblicherweise in Mengen bis zu 1 Gew.-% eingesetzt. Es sind bevorzugt langkettige Fettsäuren (z.B. Stearinsäure oder Behensäure), deren Salze (z.B. Ca- oder Zn-Stearat) oder Montanwachse (Mischungen aus geradkettigen, gesättigten Carbonsäuren mit Kettenlängen von 28 bis 32 C-Atomen) sowie Ca- oder Na-Montanat sowie niedermolekulare Polyethylen- bzw. Polypropylenwachse.

Als Beispiele für Weichmacher seien Phthalsäuredioctylester, Phthalsäuredibenzylester, Phthalsäurebutylbenzylester, Kohlenwasserstofföle, N-(n-Butyl)benzolsulfonamid genannt.

Die erfindungsgemäßen Formmassen können noch 0 bis 2 Gew.-% fluorhaltige Ethylenpolymerisate enthalten. Hierbei handelt es sich um Polymerisate des Ethylens mit einem Fluorgehalt von 55 bis 76 Gew.-%, vorzugsweise 70 bis 76 Gew.-%.

Beispiele hierfür sind Polytetrafluorethylen (PTFE), Tetrafluorethylenhexafluorpropylen-Copolymere oder Tetrafluorethylen-Copolymerisate mit kleineren Anteilen (in der Regel bis zu 50 Gew.-%) copolymerisierbarer ethylenisch ungesättigter Monomerer. Diese werden z.B. von Schildknecht in "Vinyl and Related Polymers", Wiley-Verlag, 1952, Seite 484 bis 494 und von Wall in "Fluorpolymers" (Wiley Interscience, 1972) beschrieben.

Diese fluorhaltigen Ethylenpolymerisate liegen homogen verteilt in den Formmassen vor und weisen bevorzugt eine Teilchengröße $d_{50}$ (Zahlenmittelwert) im Bereich von 0,05 bis 10 u m, insbesondere von 0,1 bis 5 $\mu$m auf. Diese geringen Teilchengrößen lassen sich besonders bevorzugt durch Verwendung von wässrigen Dispersionen von fluorhaltigen Ethylenpolymerisaten und deren Einarbeitung in eine Polyesterschmelze erzielen.

Die erfindungsgemäßen thermoplastischen Formmassen können nach an sich bekannten Verfahren hergestellt werden, in dem man die Ausgangskomponenten in üblichen Mischvorrichtungen wie Schneckenextrudern, Brabender-Mühlen oder Banbury-Mühien mischt und anschließend extrudiert. Nach der Extrusion kann das Extrudat abgekühlt und zerkleinert werden. Es können auch einzelne Komponenten vorgemischt werden und dann die restlichen Ausgangsstoffe einzeln und/oder ebenfalls gemischt hinzugegeben werden. Die Mischtemperaturen liegen in der Regel bei 230 bis 290°C.

Nach einer weiteren bevorzugten Arbeitsweise können die Komponenten B) sowie gegebenenfalls C) mit einem Polyesterpräpolymeren gemischt, konfektioniert und granuliert werden. Das erhaltene Granulat wird in fester Phase anschließend unter Inertgas kontinuierlich oder diskontinuierlich bei einer Temperatur unterhalb des Schmelzpunktes der Komponente A) bis zur gewünschten Viskosität kondensiert.

Wesentlich für das erfindungsgemäße Verfahren ist der Einsatz des hyperverzweigten Additives B1 und/oder B2 zur Verbesserung der Haftung bei Mehrkomponentenformkörpern. Hierunter wird im Sinne der Erfindung verstanden, dass mindestens 2 Schichten, vorzugsweise 2 bis 5 Schichten vorliegen, wobei mindestens eine Schicht aus der Poiyesterzusammensetzung gemäß Anspruch 1 besteht und mindestens eine andere Schicht aus Metall, Lack oder Klebstoff sowie sonstigen Beschichtungsmassen aufgebaut ist, wobei diese in direktem Kontakt mit der Polyesterschicht stehen sollte. Hierbei kann der Aufbau des Mehrkomponentenformkörpers schichtweise übereinander oder auch mit sogenanntem fließenden Übergang der Schichten erfolgen.

Als geeignete Metallschichten seien insbesondere solche aus Gold, Silber, Platin, Chrom, Aluminium, Kupfer, Titan, Nickel, Zinn und Zink oder deren Mischungen genannt.

Bei der Metallisierung kann eine Vorbehandlung erforderlich sein, beispielsweise durch Quellen, Plasmaaktivierung, Ätzung, Sputtern (Magnetstrahlbeschuss) usw., wobei anschließend insbesondere mittels PVD oder CVD metallisiert wird.

Neben der Abscheidung metallischer Schichten in chemisch oder galvanisch reaktiven Tauchbadprozessen, wurden alternative Dünnschichtverfahren zur Direktmetallisierung von Kunststoffen entwickelt. Die Beschichtungsmaterialien werden dabei unter Vakuum oder definierter Gasatmosphäre in die Gasphase überführt und kondensieren an der Bauteiloberfläche. In Abhängigkeit der Ausgangssubstanz vor der Gasphase wird zwischen physikalischen (PVD = physical vapour deposition) und chemischen Abscheideverfahren (CVD = chemical vapour deposition) überschieden.

Für die Metallisierung von Kunststoffen werden aufgrund der niedrigeren Temperatur und der einfacheren Prozesssteuerung häufig die PVD-Verfahren eingesetzt. Neben der guten Umweltverträglichkeit bieten die PVD-Verfahren bessere Flexibilität und damit ein breiteres Anwendungsspektrum als chemisch-galvanische Prozesse. Andererseits bedarf es aufgrund der niedrigen Prozessdrücke aufwendiger Anlagentechnik.

Prinzipiell werden zwei PVD-Verfahren unterschieden. Zum einen die kostengünstigere Variante des Bedampfens, bei der durch Zufuhr thermischer Energie Metall verdampft werden. Zum anderen wird das Aufstäuben (Sputtern) von Substratmaterial mit Hilfe eines ionisierten Prozessgases großtechnisch eingesetzt. Dabei wird in der Gasphase ein Prozessgas (meist Argon) ionisiert und durch ein Magnetfeld auf das abzuscheidende Material (Target) beschleunigt (Magnetronsputtern). Durch Impulsübertragung der ionisierten Gasatome werden Atome und Atomcluster aus dem Target herausgeschlagen und lagern such auf den Substraten im Vakuumrezipienten ab.

Die PVD-Metallisierung von Polymeren wird in vielen Bereichen beispielsweise für dekorative und reflektierende Beschichtungen eingesetzt. Darüber hinaus wird die Technologie aber auch für Anwendungen in der Elektronik, wie beispielsweise für elektromagnetische Abschirmschichten in elektronischen Gebrauchsgegenständen eingesetzt.

Neuere Entwicklungen beschäftigen sich mit der selektiven Metallisierung von Kunststoffbauteilen, die bei elektromechanischen Bauelementen und s.g. Moulded Interconnected Devices (3D-MID) von Interesse ist. Dabei wird das Dünnschichtverfahren für die Beschichtung von schwer metallisierbaren Polymeren mit einer Dauergebrauchstemperatur bis zu 260°C eingesetzt.

Eine weitere Möglichkeit der Anwendung besteht in der guten Barrierewirkung metallischer Werkstoffe. So kann beispielsweise eine metallische Schicht Diffusionsvorgänge in Kunststoffbehältern einschränken.

Metallisierte Formkörper werden wie im einleitenden Teil (S. 1) sowie vorstehend beschrieben eingesetzt.

In einer weiteren bevorzugten Ausführungsform der vorliegenden Erfindung können die erfindungsgemäßen Polyesterformmassen eine verbesserte Haftung zu Lacken, beispielsweise zu Klar- und Decklacken, beispielsweise in Beschichtungsmassen, gegebenenfalls gemeinsam mit anderen Hydroxy- oder Aminogruppen aufweisenden Bindemitteln, zum Beispiel mit Hydroxy(meth)acrylaten, Hydroxystyryl(meth)acrylaten, linearen oder verzweigten Polyestern, Polyethern, Polycarbonaten, Melaminharzen oder Harnstoff-Formaldehydharzen, zusammen mit gegenüber Carboxy- und/oder Hydroxyfunktionen reaktiven Verbindungen aufweisen. Diese Bindemittel lassen sich beispielsweise mit Isocyanaten, verkappten Isocyanaten, Epoxiden und/oder Aminoplasten, bevorzugt Isocyanaten, Epoxiden oder Aminoplasten, besonders bevorzugt mit Isocyanaten oder Epoxiden und ganz besonders bevorzugt mit Isocyanaten vernetzen.

Isocyanate sind beispielsweise aliphatische, aromatische und cycloaliphatische Di- und Polyisocyanate mit einer mittleren NCO-Funktionalität von mindestens 1,8, bevorzugt 1,8 bis 5 und besonders bevorzugt 2 bis 4, sowie deren Isocyanurate, Oxadiazintrione, Iminooxadiazindione, Harnstoffe, Biurete, Amide, Urethane, Allophanate, Carbodiimide, Uretonimine und Uretdione.

Bei den Diisocyanaten handelt es sich bevorzugt um Isocyanate mit 4 bis 20 C-Atomen. Beispiele für übliche Diisocyanate sind aliphatische Diisocyanate wie Tetramethylendiisocyanat, Hexamethylendiisocyanat (1,6-Diisocyanatohexan), Octamethylendiisocyanat, Decamethylendiisocyanat, Dodecamethylendiisocyanat, Tetradecamethylendiisocyanat, Derivate des Lysindiisocyanates, Trimethylhexandiisocyanat oder Tetramethylhexandiisocyanat, cycloaliphatische Diisocyanate wie 1,4-, 1,3- oder 1,2-Diisocyanatocyclohexan, 4,4'- oder 2,4'-Di(isocyanatocyclohexyl)methan, 1-Isocyanato-3,3,5- trimethyl-5-(isocyanatomethyl)cyclohexan (Isophorondiisocyanat), 1,3- oder 1,4-Bis(isocyanatomethyl)cyclohexan oder 2,4-, oder 2,6-Diisocyanato-1-methylcyclohexan sowie aromatische Diisocyanate wie 2,4- oder 2,6-Toluylendiisocyanat und deren Isomerengemische, m- oder p-Xylylendiisocyanat, 2,4'- oder 4,4'-Diisocyanatodiphenylmethan und deren Isomerengemische, 1,3- oder 1,4-Phenylendiisocyanat, 1-Chlor-2,4-phenylendiisocyanat, 1,5-Naphthylendiisocyanat, Diphenylen-4,4'-diisocyanat, 4,4'-Diisocyanato-3,3'-dimethyldiphenyl, 3-Methyldiphenylmethan-4,4'-diisocyanat, Tetramethylxylylendiisocyanat 1,4-Diisocyanatobenzol oder Diphenylether-4,4'-diisocyanat.

Es können auch Gemische der genannten Diisocyanate vorliegen.

Als Polyisocyanate kommen Isocyanuratgruppen aufweisende Polyisocyanate, Uretdiondiisocyanate, Biuretgruppen aufweisende Polyisocyanate, Amidgruppen aufweisende Polyisocyanate, Urethan- oder Allophanatgruppen aufweisende Polyisocyanate, Oxadiazintriongruppen oder Iminooxadiazindiongruppen enthaltende Polyisocyanate, Carbodiimid- oder Uretonimin-modifizierte Polyisocyanate von geradlinigen oder verzweigten $C_4$-$C_{20}$-Alkylendiisocyanaten, cycloaliphatischen Diisocyanaten mit insgesamt 6 bis 20 C-Atomen oder aromatischen Diisocyanaten mit insgesamt 8 bis 20 C-Atomen oder deren Gemische in Betracht.

Die einsetzbaren Di- und Polyisocyanate haben bevorzugt einen Gehalt an Isocyanatgruppen (berechnet als NCO, Molekulargewicht = 42) von 1 bis 60 Gew.-% bezogen auf das Di- und Polyisocyanat(gemisch), bevorzugt 2 bis

60 Gew.-% und besonders bevorzugt 10 bis 55 Gew.-%.

Bevorzugt sind aliphatische bzw. cycloaliphatische Di- und Polyisocyanate, z.B. die vorstehend genannten aliphatischen bzw. cycloaliphatischen Diisocyanate, oder deren Mischungen.

Besonders bevorzugt sind Hexamethylendiisocyanat, 1,3-Bis(isocyanatomethyl)cyclohexan, Isophorondiisocyanat und Di(isocyanatocyclohexyl)methan, ganz besonders bevorzugt sind Isophorondiisocyanat und Hexamethylendiisocyanat, insbesondere bevorzugt ist Hexamethylendiisocyanat.

Weiterhin bevorzugt sind

1) Isocyanuratgruppen aufweisende Polyisocyanate von aromatischen, aliphatischen und/oder cycloaliphatischen Diisocyanaten. Besonders bevorzugt sind hierbei die entsprechenden aliphatischen und/oder cycloaliphatischen Isocyanato-Isocyan-urate und insbesondere die auf Basis von Hexamethylendiisocyanat und Isophoron-diisocyanat. Bei den dabei vorliegenden Isocyanuraten handelt es sich insbesondere um Tris-isocyanatoalkyl- bzw. Tris-isocyanatocycloalkyl-Isocyanurate, welche cyclische Trimere der Diisocyanate darstellen, oder um Gemische mit ihren höheren, mehr als einen Isocyanuratring aufweisenden Homologen. Die Isocyanato-Isocyanurate haben im allgemeinen einen NCO-Gehalt von 10 bis 30 Gew.-%, insbesondere 15 bis 25 Gew.-% und eine mittlere NCO-Funktionalität von 2,6 bis 4,5.

2) Uretdiondiisocyanate mit aromatisch, aliphatisch und/oder cycloaliphatisch gebundenen Isocyanatgruppen, vorzugsweise aliphatisch und/oder cycloaliphatisch gebundenen und insbesondere die von Hexamethylendiisocyanat oder Isophorondiisocyanat abgeleiteten. Bei Uretdiondiisocyanaten handelt es sich um cyclische Dimerisierungsprodukte von Diisocyanaten.
Die Uretdiondiisocyanate können in den erfindungsgemäßen Zubereitungen als alleinige Komponente oder im Gemisch mit anderen Polyisocyanaten, insbesondere den unter 1) genannten, eingesetzt werden.

3) Biuretgruppen aufweisende Polyisocyanate mit aromatisch, cycloaliphatisch oder aliphatisch gebundenen, bevorzugt cycloaliphatisch oder aliphatisch gebundenen Isocyanatgruppen, insbesondere Tris(6-isocyanatohexyl)biuret oder dessen Gemische mit seinen höheren Homologen. Diese Biuretgruppen aufweisenden Polyisocyanate weisen im allgemeinen einen NCO-Gehalt von 18 bis 23 Gew.-% und eine mittlere NCO-Funktionalität von 2,8 bis 4,5 auf.

4) Urethan- und/oder Allophanatgruppen aufweisende Polyisocyanate mit aromatisch, aliphatisch oder cycloaliphatisch gebundenen, bevorzugt aliphatisch oder cycloaliphatisch gebundenen Isocyanatgruppen, wie sie beispielsweise durch Umsetzung von überschüssigen Mengen an Hexamethylendiisocyanat oder an Isophorondiisocyanat mit ein- oder mehrwertigen Alkoholen wie z.B. Methanol, Ethanol, *iso*-Propanol, n-Propanol, n-Butanol, *iso*-Butanol, *sek*-Butanol, *tert*-Butanol, n-Pentanol, n-Hexanol, n-Heptanol, n-Octanol, n-Decanol, n-Dodecanol (Laurylalkohol), 2-Ethylhexanol, Stearylalkohol, Cetylalkohol, Laurylalkohol, Ethylenglykolmonomethylether, Ethylenglykolmonoethylether, 1,3-Propandiolmonomethylether, Cyclopentanol, Cyclohexanol, Cyclooctanol, Cyclododecanol oder mehrwertige Alkohole, wie sie oben bei den Polyesterolen aufgeführt sind, oder deren Gemischen erhalten werden können. Diese Urethan- und/oder Allophanatgruppen aufweisenden Polyisocyanate haben im allgemeinen einen NCO-Gehalt von 12 bis 20 Gew.-% und eine mittlere NCO-Funktionalität von 2,5 bis 4,5.

5) Oxadiazintriongruppen enthaltende Polyisocyanate, vorzugsweise von Hexamethylendiisocyanat oder Isophorondiisocyanat abgeleitet. Solche Oxadiazintriongruppen enthaltenden Polyisocyanate sind aus Diisocyanat und Kohlendioxid herstellbar.

6) Iminooxadiazindiongruppen enthaltende Polyisocyanate, vorzugsweise von Hexamethylendiisocyanat oder Isophorondiisocyanat abgeleitet. Solche Iminooxadiazindiongruppen enthaltenden Polyisocyanate sind aus Diisocyanaten mittels spezieller Katalysatoren herstellbar.

7) Carbodiimid- und/oder Uretonimin-modifizierte Polyisocyanate.

Die Polyisocyanate 1) bis 7) können im Gemisch, gegebenenfalls auch im Gemisch mit Diisocyanaten, eingesetzt werden.

Die Isocyanatgruppen der Di- oder Polyisocyanate können auch in verkappter Form vorliegen. Als Verkappungsmittel für NCO-Gruppen eignen sich z.B. Oxime, Phenole, Imidazole, Pyrazole, Pyrazolinone, Triazole, Diketopiperazine, Caprolactam, Malonsäureester oder Verbindungen, wie sie genannt sind in den Veröffentlichungen von Z.W. Wicks, Prog. Org. Coat. 3 (1975) 73 - 99 und Prog. Org. Coat 9 (1981), 3 - 28, von D.A. Wicks und Z.W. Wicks, Prog. Org. Coat. 36 (1999), 148 -172 und Prog. Org. Coat. 41 (2001), 1 - 83 sowie in Houben-Weyl, Methoden der Organischen

Chemie, Bd. XIV/2, 61 ff. Georg Thieme Verlag, Stuttgart 1963.

Unter Verkappungs- bzw. Blockierungsmitteln werden dabei Verbindungen verstanden, die Isocyanatgruppen in blockierte (verkappte bzw. geschützte) Isocyanatgruppen umwandeln, die dann unterhalb der sogenannten Deblockierungstemperatur nicht die üblichen Reaktionen einer freien Isocyanatgruppe zeigen. Solche Verbindungen mit blockierten Isocyanatgruppen kommen üblicherweise in Dual-Cure-Beschich-tungsmittein oder in Pulverlacken zur Anwendung, die über Isocyanatgruppenhärtung endgehärtet werden.

Epoxidverbindungen sind solche mit mindestens einer, bevorzugt mit mindestens zwei, besonders bevorzugt zwei bis zehn Epoxidgruppen im Molekül.

In Betracht kommen z.B. epoxidierte Olefine, Glycidylester (z.B. Glycidyl(meth)acrylat) von gesättigten oder ungesättigten Carbonsäuren oder Glycidylether aliphatischer oder aromatische Polyole. Derartige Produkte werden im Handel in großer Zahl angeboten. Besonders bevorzugt sind Polyglycidylverbindungen vom Bisphenol A-, -F- oder -BTyp und Glycidylether mehrfunktioneller Alkohole, z.B. des Butandiol, des 1,6-Hexandiol, des Glycerin und des Pentaerythrit. Beispiele für derartige Polyepoxidverbindungen sind Epikote® 812 (Epoxidwert: ca. 0,67 mol/100g) und Epikote® 828 (Epoxidwert: ca. 0,53 mol/100g), Epikote® 1001, Epikote® 1007 und Epikote® 162 (Epoxidwert: ca. 0,61 mol/100g) der Firma Resolution, Rütapox® 0162 (Epoxidwert: ca. 0,58 mol/100g), Rütapox® 0164 (Epoxidwert: ca. 0,53 mol/100g) und Rütapox® 0165 (Epoxidwert: ca. 0,48 mol/100g) der Firma Bakelite AG, Araldit® DY 0397 (Epoxidwert: ca. 0,83 mol/100g) der Firma Vantico AG.

Weiterhin kommen Verbindungen mit aktiven Methylol- oder Alkylalkoxygruppen, insbesondere Methylalkoxygruppen in Frage, wie z.B veretherte Umsetzungsprodukte von Formaldehyd mit Aminen, wie Melamin, Harnstoff etc., Phenol/Formaldehyd-addukte, Siloxan oder Silangruppen und Anhydride, wie sie z.B. in US-5, 770,650 beschrieben sind.

Unter den technisch weit verbreiteten und bekannten, bevorzugten Aminoplasten sind besonders bevorzugt Harnstoffharze und Melaminharze, wie z.B. Harnstoff-Formaldehyd-Harze, Melamin-Formaldehyd-Harze, Melamin-Phenol-Formaldehyd-Harze oder Melamin-Harnstoff-Formaldehyd-Harze, verwendbar.

Als Harnstoffharze sind solche geeignet, die durch Umsetzung von Harnstoffen mit Aldehyden erhältlich sind und gegebenenfalls modifiziert werden können.

Als Harnstoffe sind Harnstoff, N-substituierte oder N,N'-disubstituierte Harnstoffe geeignet, wie z.B. N-Methylharnstoff, N-Phenylharnstoff, N,N'-Dimethylharnstoff, Hexamethylendiharnstoff, N,N'-Diphenylharnstoff, 1,2-Ethylendiharnstoff, 1,3-Propylendiharnstoff, Diethylentriharnstoff, Dipropylentriharnstoff, 2-Hydroxypropylendiharnstoff, 2-Imidazolidinon (Ethylenharnstoff), 2-Oxohexahydropyrimidin (Propylenharnstoff) oder 2-Oxo-5-Hydroxyhexahydropyrimidin (5-Hydroxypropylenharnstoff).

Harnstoffharze können gegebenenfalls teilweise oder vollständig modifiziert werden, z.B. durch Umsetzung mit mono- od. polyfunktionellen Alkoholen, Ammoniak bzw. Aminen (kationisch modifizierte Harnstoffharze) oder mit (Hydrogen)sulfiten (anionisch modifizierte Harnstoffharze), insbesondere geeignet sind die alkoholmodifizierten Harnstoffharze.

Als Alkohole kommen für die Modifizierung $C_1$-$C_6$-Alkohole in Frage, bevorzugt $C_1$-$C_4$-Alkohol und insbesondere Methanol, Ethanol, *iso*-Propanol, n-Propanol, n-Butanol, *iso*-Butanol und *sek*-Butanol.

Als Melaminharze sind solche geeignet, die durch Umsetzung von Melamin mit Aldehyden erhältlich sind und gegebenenfalls teilweise oder vollständig modifiziert werden können.

Als Aldehyde sind insbesondere Formaldehyd, Acetaldehyd, *iso*-Butyraldehyd und Glyoxal geeignet.

Melamin-Formaldehyd-Harze sind Reaktionsprodukte der Umsetzung von Melamin mit Aldehyden, z.B. den o.g. Aldehyden, insbesondere Formaldehyd. Gegebenenfalls werden die erhaltenen Methylol-Gruppen durch Veretherung mit den oben genannten ein- oder mehrwertigen Alkoholen modifiziert. Weiterhin können die Melamin-Formaldehyd-Harze auch wie oben beschrieben durch Reaktion mit Aminen, Aminocarbonsäuren oder Sulfiten modifiziert werden.

Durch Einwirkung von Formaldehyd auf Mischungen von Melamin und Harnstoff beziehungsweise auf Mischungen aus Melamin und Phenol entstehen erfindungsgemäß ebenfalls verwendbare Melamin-Harnstoff-Formaldehyd-Harze beziehungsweise Melamin-Phenol-Formaldehyd-Harze.

Die Herstellung der genannten Aminoplaste erfolgt nach an sich bekannten Verfahren.

Besonders genannte Beispiele sind Melamin-Formaldehyd-Harze, einschließlich monomerer oder polymerer Melaminharze und teilweise oder vollständig alkylierte Melaminharze, Harnstoff-Harze, z.B. Methylolharnstoffe wie Formaldehyd-Harnstoff-Harze, Alkoxyharnstoffe wie butylierte Formaldehyd-Harnstoff-Harze, aber auch N-Methylol-acrylamid-emulsionen, *iso*-Butoxy methyl acrylamid-emulsionen, Polyanhydride, wie z.B. Polybernsteinsäureanhydrid, und Siloxane oder Silane, z.B. Dimethyldimethoxysilane.

Besonders bevorzugt sind Aminoplastharze wie Melamin-Formaldehyd-Harze oder Formaldehyd-Harnstoff-Harze.

Bei den Lacken oder Beschichtungen kann es sich um konventionelle Basislacke, Wasserbasislacke, im wesentlichen lösemittel- und wasserfreie flüssige Basislacke (100%-Systeme), im wesentlichen lösemittel- und wasserfreie feste Basislacke (Pulverlacke und pigmentierte Pulverlacke) oder im wesentlichen lösemittelfreie, ggf. pigmentierte Pulverlackdispersionen (Pulverslurry-Basislacke) handeln. Sie können thermisch, strahlungs- oder DualCure-härtbar,

und selbst- oder fremdvernetzend sein.

Zur Beschichtung wird üblicherweise in an sich bekannter Weise beschichtet, anschließend zur Entfernung von gegebenenfalls vorhandenem Lösungsmittel getrocknet und gehärtet.

Die Beschichtung der Polyesterschicht erfolgt nach üblichen, dem Fachmann bekannten Verfahren, wobei man wenigstens eine erfindungsgemäße Beschichtungsmasse auf das zu beschichtende Substrat in der gewünschten Stärke aufbringt und die flüchtigen Bestandteile entfernt. Dieser Vorgang kann gewünschtenfalls ein- oder mehrfach wiederholt werden. Das Aufbringen auf die Polyesterschicht kann in bekannter Weise, z. B. durch Spritzen, Spachteln, Rakeln, Bürsten, Rollen, Walzen oder Gießen erfolgen. Die Beschichtungsstärke liegt in der Regel in einem Bereich von etwa 3 bis 1000 $g/m^2$ und vorzugsweise 10 bis 200 $g/m^2$.

Als Anwendungen seien insbesondere genannt:

Lackierung von Kfz-Außenteilen, Formteilen im Außen- oder Innenbereich, Haushaltsgeräten oder Geräteteilen, Gehäuseteilen oder auch Schutzlackierungen für metallisierte Formkörper.

Beispiele

Komponente A:

Polybutylenterephthalat mit einer Viskositätszahl VZ von 130 ml/g und einem Carboxylendgruppengehalt von 34 mva/kg (Ultradur® B 4520 der BASF AG) (VZ gemessen in 0,5 gew.-%iger Lösung aus Phenol/o-Dichlorbenzol), 1:1-Mischung bei 25°C, enthaltend 0,65 Gew.-% Pentaerythrittetrastearat (Komponente C1 bezogen auf 100 Gew.-% A)

Herstellvorschrift für Polycarbonate B1

Allgemeine Arbeitsvorschrift:

In einem Dreihalskolben, ausgestattet mit Rührer, Rückflusskühler und Innenthermometer wurde gemäß Tabelle 1 der mehrfunktionelle Alkohol äquimolar mit Diethylcarbonat gemischt und 250 ppm Katalysator (bezogen auf die Menge an Alkohol) zugegeben. Die Mischung wurde anschließend unter Rühren auf 100°C, bei dem mit * gekennzeichneten Versuch auf 140°C erwärmt, und 2 h bei dieser Temperatur gerührt. Mit fortschreitender Reaktionsdauer reduzierte sich dabei die Temperatur des Reaktionsgemisches bedingt durch die einsetzende Siedekühlung des freigesetzten Monoalkohols. Nun wurde der Rückflusskühler gegen einen absteigenden Kühler getauscht, Ethanol abdestilliert und die Temperatur des Reaktionsgemisches langsam bis auf 160°C erhöht.

Das abdestillierte Ethanol wurde in einem gekühlten Rundkolben gesammelt, ausgewogen und der Umsatz so gegenüber dem theoretisch möglichen Vollumsatz prozentual ermittelt (siehe Tabelle 1).

Die Reaktionsprodukte wurden anschließend per Gelpermeationschromatographie analysiert, Laufmittel war Dimethylacetamid, als Standard wurde Polymethylmethacrylat (PMMA) verwendet.

Tabelle 1:

| Alkohol | Katalysator | Destillat Ethanol menge bez. auf Vollumsatz [Mol %] | Molekulargewicht $M_w$ $M_n$ | Visk. 23°C [m Pas] | OH-Zahl [mg KOH/g] |
|---|---|---|---|---|---|
| TMP x 1,2 PO | $K_2CO_3$ | 90 | 1836<br>1292 | 7150 | 455 |

TMP ≙ Trimethylolpropan
PO ≙ Propylenoxid

Herstellung der Formmassen

Die Komponenten A) bis C) wurde auf einem Zweischneckenextruder bei 250 bis 260°C abgemischt und in ein Wasserbad extrudiert. Nach Granulierung und Trocknung wurden auf einer Spritzgussmaschine Prüfkörper gespritzt und geprüft.

Zur Prüfung der Oberflächenhaftung wurden Schulterstäbe nach ISO 527-2 hergestellt und metallisiert. Die Metallisierung erfolgte über Aufdampfen von Cu (Physical vapour deposition, PVD):

Horizontale Bedampfungsanlage "Meta 1100 Arc"

1100 $dm^3$ Kammervolumen Bauteildimension bis zu 1000 mm Länge und 200 mm Durchmesser. Probekörper: Zugstäbe nach ISO 527-2.

Die zu beschichtenden Teile wurden in der Vakuumkammer auf einem Drehkorb befestigt und rotierten während der Bedampfung um die Verdampfereinheit.

Nach dem Schließen der Vakuumkammer erfolgte die Evakuierung der Anlage auf einen Druck von ca. 1 x $10^{-4}$ mbar. Die Verdampfung des Cu-Metalis erfolgte mit widerstandsbeheizten Quellen (Wendel/Schiffchen).

Die typische Schichtdicke liegt je nach Anwendungsfall zwischen 50 Nanometern (0,00005 mm) bis zu einigen Mikrometern, z.B. bei elektromagnetischen Abschirmschichten (EMV).

Anschließend wurde die Anhaftung des Metalls an die Kunststoffoberfläche in einem Schälversuch nach DIN EN 60249 bestimmt. Der Schälwiderstand wurde mit einem metallisierten Stab in 20 Wiederholungen gemessen und der Mittelwert der Schälhaftfestigkeit verglichen:

Hierbei wurden an den Testkörpern jeweils Kupferstreifen im Winkel und 90° abgezogen. Das Abschälen der Kupferstreifen erfolgte mit einer Abzugsgeschwindigkeit von 50 mm/min über eine Länge von mindestens 25 mm. Aufgezeichnet wurde die Abschälkraft F in Abhängigkeit des Weges X.

Probe 1: Komponente A) + 1 Gew.-% B1
Probe 2: Komponente A) ohne B1 (zum Vergleich)

Die Ergebnisse der Messungen sind den Tabellen 2 und 3 zu entnehmen.

Tabelle 2: Schälversuch von Probe 1, 20 Wiederholungen mit Mittelwert und Standardabweichung

| | Schälhaftfestigkeit (N/mm) | Fmax (N) | Fmin (N) | Stadev (N) | Varianz (N) | Länge (mm) |
|---|---|---|---|---|---|---|
| Probe 1 | | | | | | |
| P1-1 | 0,76 | 1,10 | 0,04 | 0,23 | 0,16 | 77,32 |
| P1-2 | 1,01 | 1,42 | 0,03 | 0,27 | 0,22 | 78,77 |
| P1-3 | 1,15 | 1,44 | 0,81 | 0,11 | 0,03 | 53,97 |
| P1-4 | 0,65 | 1,40 | 0,41 | 0,29 | 0,26 | 63,25 |
| P1-5 | 0,66 | 1,11 | 0,42 | 0,14 | 0,06 | 36,15 |
| P1-6 | 0,70 | 1,27 | 0,18 | 0,28 | 0,23 | 62,27 |
| P1-7 | 0,86 | 1,21 | 0,41 | 0,09 | 0,03 | 64,17 |
| P1-8 | 1,53 | 2,16 | 1,01 | 0,23 | 0,16 | 42,27 |
| P1-9 | 1,00 | 1,43 | 0,02 | 0,23 | 0,15 | 78,10 |
| P1-10 | 1,18 | 1,65 | 0,62 | 0,18 | 0,10 | 52,63 |
| P1-11 | 1,00 | 1,25 | 0,78 | 0,09 | 0,03 | 74,90 |
| P1-12 | 1,29 | 1,79 | 0,95 | 0,14 | 0,06 | 72,13 |
| P1-13 | 1,04 | 1,53 | 0,74 | 0,17 | 0,08 | 74,50 |
| P1-14 | 1,17 | 1,87 | 0,44 | 0,26 | 0,20 | 55,23 |
| P1-15 | 1,18 | 1,45 | 0,78 | 0,14 | 0,06 | 48,18 |
| P1-16 | 0,87 | 1,70 | 0,17 | 0,45 | 0,61 | 70,33 |
| P1-17 | 0,96 | 1,41 | 0,47 | 0,15 | 0,07 | 69,53 |
| P1-18 | 1,47 | 2,30 | 0,93 | 0,25 | 0,19 | 45,57 |
| P1-19 | 1,30 | 1,84 | 0,98 | 0,15 | 0,07 | 70,88 |
| P1-20 | 1,03 | 1,83 | 0,30 | 0,36 | 0,39 | 42,75 |
| Mittel wert | 1,04 | 1,56 | 0,51 | 0,21 | 0,16 | |

Tabelle 3: Schälversuch von Probe 2, 20 Wiederholungen mit Mittelwert und Standardabweichung

| | Schälhaftfestigkeit (N/mm) | Fmax (N) | Fmin (N) | Stadev (N) | Varianz (N) | Länge (mm) |
|---|---|---|---|---|---|---|
| Probe 2 | | | | | | |
| P2-1 | 0,45 | 0,69 | 0,23 | 0,12 | 0,04 | 55,87 |
| P2-2 | 0,73 | 1,75 | 0,17 | 0,35 | 0,37 | 66,78 |
| P2-3 | 0,69 | 0,92 | 0,50 | 0,08 | 0,02 | 58,58 |
| P2-4 | 0.84 | 1,53 | 0,35 | 0,26 | 0,20 | 62,47 |
| P2-5 | 0,62 | 0,87 | 0,30 | 0,11 | 0,03 | 66,97 |
| P2-6 | 0,78 | 1,66 | 0,19 | 0,34 | 0,34 | 65,23 |
| P2-7 | 0,56 | 0,93 | 0,25 | 0,12 | 0,04 | 63,42 |
| P2-8 | 0,23 | 0,56 | 0,08 | 0,10 | 0,03 | 54,90 |
| P2-9 | 0,64 | 0,95 | 0,46 | 0,10 | 0,03 | 67,80 |
| P2-10 | 0,94 | 1,41 | 0,31 | 0,23 | 0,16 | 59,70 |
| P2-11 | 0,45 | 0,73 | 0,26 | 0,10 | 0,03 | 77,85 |
| P2-12 | 1,13 | 1,58 | 0,55 | 0,19 | 0,11 | 72,15 |
| P2-13 | 1,42 | 1,94 | 0,81 | 0,25 | 0,19 | 78,42 |
| P2-14 | 0,98 | 1,44 | 0,64 | 0,17 | 0,09 | 28,72 |
| P2-15 | 0,52 | 0,80 | 0,34 | 0,09 | 0,03 | 77,88 |
| P2-16 | 0,78 | 1,34 | 0,22 | 0,27 | 0,22 | 58,05 |
| P2-17 | 0,76 | 1,11 | 0,52 | 0,11 | 0,04 | 59,77 |
| P2-18 | 0,81 | 1,40 | 0,25 | 0,24 | 0,17 | 48,47 |
| P2-19 | 0,60 | 0,91 | 0,40 | 0,10 | 0,03 | 67,57 |
| P2-20 | 1,21 | 1,93 | 0,64 | 0,23 | 0,15 | 66,98 |
| Mittel wert | 0,76 | 1,22 | 0,37 | 0,18 | 0,12 | |

## Patentansprüche

1. Verfahren zur Herstellung von Mehrkomponentenformkörpern, **dadurch gekennzeichnet, dass** mindestens eine Schicht des Formkörpers aus einer thermoplastischen Formmasse aus

   A) 10 bis 99,99 Gew.-% mindestens eines thermoplastischen Polyesters,
   B) 0,01 bis 50 Gew.-%
   B1) mindestens eines hoch- oder hyperverzweigten Polycarbonates mit einer OH-Zahl von 1 bis 600 mg KOH/g Polycarbonat (gemäß DIN 53240, Teil 2), oder
   B2) mindestens eines hoch- oder hyperverzweigten Polyesters des Typs $A_xB_y$ mit x mindestens 1,1 und y mindestens 2,1 oder deren Mischungen und
   C) 0 bis 60 Gew.-% weiterer Zusatzstoffe,

   aufgebaut ist,
   wobei die Summe der Gewichtsprozente der Komponenten A) bis C) 100 % ergibt.

2. Verfahren nach Anspruch 1, **dadurch gekennzeichnet, dass** die Komponente B1) ein Zahlenmittel des Molekulargewichtes $M_n$ von 100 bis 15000 g/mol aufweist.

3. Verfahren nach den Ansprüchen 1 oder 2, **dadurch gekennzeichnet, dass** die Komponente B1) eine Glasübergangstemperatur Tg von -80°C bis 140.°C aufweist.

4. Verfahren nach den Ansprüchen 1 bis 3, **dadurch gekennzeichnet, dass** die Komponente B1) eine Viskosität (mPas) bei 23°C (gemäß DIN 53019) von 50 bis 200000 aufweist.

5. Verfahren nach den Ansprüchen 1 bis 4, **dadurch gekennzeichnet, dass** die Komponente B2) eine OH-Zahl (gemäß DIN 53240) von 0 bis 600 mg KOH/g Polyester aufweist.

6. Verfahren nach den Ansprüchen 1 bis 5, **dadurch gekennzeichnet, dass** die Komponente B2) eine COOH-Zahl (gemäß DIN 53240) von 0 bis 600 mg KOH/g Polyester aufweist

7. Verfahren nach den Ansprüchen 1 bis 6, **dadurch gekennzeichnet, dass** die Komponente B2) wenigstens eine OH-Zahl oder COOH-Zahl größer 0 aufweist.

8. Verfahren nach den Ansprüchen 1 bis 7, **dadurch gekennzeichnet, dass** mindestens eine Schicht aus Metall, Lack, Klebstoff oder Beschichtungsmassen in Kontakt mit der Polyesterschicht steht.

9. Verfahren nach den Ansprüchen 1 bis 8, **dadurch gekennzeichnet, dass** die Metallschicht aus Gold, Silber, Platin, Chrom, Aluminium, Kupfer, Titan, Nickel, Zinn oder Zink oder deren Mischungen aufgebaut ist.

10. Verfahren nach den Ansprüchen 1 bis 9, **dadurch gekennzeichnet, dass** die Polyesterschicht gegebenenfalls vorbehandelt wird und mittels PVD (physical vapour deposition) metallisiert wird.

11. Metallisierte, lackierte oder Klebstoff sowie Beschichtungsmassen enthaltende Mehrkomponentenformkörper jeglicher Art, erhältlich gemäß dem Verfahren gemäß den Ansprüchen 1 bis 10.

## Claims

1. A process for production of multicomponent moldings, which comprises producing a molding of which at least one layer is composed of a thermoplastic molding composition composed of

   A) from 10 to 99.99% by weight of at least one thermoplastic polyester,
   B) from 0.01 to 50% by weight of
   B1) at least one highly branched or hyperbranched polycarbonate having an OH number of from 1 to 600 mg KOH/g of polycarbonate (to DIN 53240, Part 2), or
   B2) at least one highly branched or hyperbranched polyester of $A_xB_y$ type, where x is at least 1.1 and y is at least 2.1, or a mixture of these, and
   C) from 0 to 60% by weight of other additives,

   where the total of the percentages by weight of components A) to C) is 100%.

2. The process according to claim 1, wherein component B1) has a number-average molar mass $M_n$ of from 100 to 15 000 g/mol.

3. The process according to claim 1 or 2, wherein component B1) has a glass transition temperature Tg of from -80°C to 140°C.

4. The process according to claims 1 to 3, wherein component B1) has a viscosity (mPas) at 23°C (to DIN 53019) of from 50 to 200 000.

5. The process according to claims 1 to 4, wherein component B2) has an OH number (to DIN 53240) of from 0 to 600 mg KOH/g of polyester.

6. The process according to claims 1 to 5, wherein component B2) has a COOH number (to DIN 53240) of from 0 to 600 mg KOH/g of polyester.

7. The process according to claims 1 to 6, wherein component B2) has at least one OH number or COOH number

greater than 0.

**8.** The process according to claims 1 to 7, wherein at least one layer composed of metal, lacquer, adhesive, or coating compositions is in contact with the polyester layer.

**9.** The process according to claims 1 to 8, wherein the metal layer is composed of gold, silver, platinum, chromium, aluminum, copper, titanium, nickel, tin, or zinc, or a mixture of these.

**10.** The process as claimed in claims 1 to 9, wherein the polyester layer is, if appropriate, pretreated, and is metallized by means of PVD (physical vapor deposition).

**11.** A multicomponent molding of any type which has been metallized or lacquered, or which comprises adhesive or else comprises coating compositions, and which is obtainable according to the process according to claims 1 to 10.

## Revendications

**1.** Procédé de fabrication de corps moulés multicomposants, **caractérisé en ce qu'**au moins une couche du corps moulé est formée à partir d'un matériau de moulage thermoplastique constitué par :

A) 10 à 99,99 % en poids d'au moins un polyester thermoplastique,
B) 0,01 à 50 % en poids de
B1) au moins un polycarbonate hautement ou hyperramifié ayant un indice OH de 1 à 600 mg KOH/g de polycarbonate (selon DIN 53240, partie 2) ou
B2) au moins un polyester hautement ou hyper-ramifié de type $A_xB_y$ avec x valant au moins 1,1 et y valant au moins 2,1,
ou leurs mélanges, et
C) 0 à 60 % en poids d'additifs supplémentaires,

la somme des pourcentages en poids des composants A) à C) étant de 100 %.

**2.** Procédé selon la revendication 1, **caractérisé en ce que** le composant B1) présente une moyenne en nombre du poids moléculaire $M_n$ de 100 à 15 000 g/mol.

**3.** Procédé selon les revendications 1 ou 2, **caractérisé en ce que** le composant B1) présente une température de transition vitreuse Tg de -80°C à 140 °C.

**4.** Procédé selon les revendications 1 à 3, **caractérisé en ce que** le composant B1) présente une viscosité (mPas) à 23 °C (selon DIN 53019) de 50 à 200 000.

**5.** Procédé selon les revendications 1 à 4, **caractérisé en ce que** le composant B2) présente un indice OH (selon DIN 53240) de 0 à 600 mg KOH/g de polyester.

**6.** Procédé selon les revendications 1 à 5, **caractérisé en ce que** le composant B2) présente un indice COOH (selon DIN 53240) de 0 à 600 mg KOH/g de polyester.

**7.** Procédé selon les revendications 1 à 6, **caractérisé en ce que** le composant B2) présente au moins un indice OH ou un indice COOH supérieur à 0.

**8.** Procédé selon les revendications 1 à 7, **caractérisé en ce qu'**au moins une couche en métal, vernis, adhésif ou matériaux de revêtement est en contact avec la couche de polyester.

**9.** Procédé selon les revendications 1 à 8, **caractérisé en ce que** la couche métallique est en or, argent, platine, chrome, aluminium, cuivre, titane, nickel, étain ou zinc ou leurs mélanges.

**10.** Procédé selon les revendications 1 à 9, **caractérisé en ce que** la couche de polyester est éventuellement prétraitée et métallisée par PVD (physical vapour deposition).

**11.** Corps moulés multicomposants de tout type, métallisés, vernis ou contenant un adhésif et des matériaux de revêtement, pouvant être obtenus par le procédé selon les revendications 1 à 10.

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

### In der Beschreibung aufgeführte Patentdokumente


- US 6497959 B
- WO 2006042673 A
- DE 4401055 A
- US 3651014 A
- DE OS3334782 A
- DE OS2842005 A
- DE 3506472 A
- EP 711810 A
- EP 365916 A
- DE 10138216
- DE 10147712
- DE 10163163 A
- EP 208187 A
- EP 50265 A
- US PS4148846 A
- DE 3725576 A
- EP 235690 A
- DE 3800603 A
- EP 319290 A
- US 5770650 A


### In der Beschreibung aufgeführte Nicht-Patentliteratur


- *Kunststoffe,* 1999, vol. 53, 3
- *Surface and Coatings Technology,* 1997, 372-377
- *J. Electrochemical Soc.,* 1997, vol. 144 (3), 1131-1135
- *Nucl. Instr. Meth. Phys. Res. B,* 1999, vol. 151, 279-284
- **P.J. FLORY.** *J. Am. Chem. Soc.,* 1952, vol. 74, 2718
- **H. FREY et al.** *Chem. Eur. J.,* 2000, vol. 6 (14), 2499
- **H. FREY et al.** Degree of Branching. *Acta Polym.,* 1997, vol. 48, 30
- Ullmann's Encyclopedia of Industrial Chemistry. Electronic Release. Verlag Wiley-VCH, 2000
- Immobilization. **KURT FABER.** Biotransformations in organic chemistry. Springer Verlag, 1997, 345-356
- **A. SUNDER et al.** *Chem. Eur. J.,* 2000, vol. 6 (1), 1-8
- **HOUBEN-WEYL.** Methoden der organischen Chemie. Georg-Thieme-Verlag, 1961, vol. 14/1, 392-406
- Toughened Plastics. **VON C.B. BUCKNALL.** Monographie. Applied Science Publishers, 1977
- **VON SCHILDKNECHT.** Vinyl and Related Polymers. Wiley-Verlag, 1952, 484-494
- **VON WALL.** Fluorpolymers. Wiley Interscience, 1972
- **VON Z.W. WICKS.** *Prog. Org. Coat.,* 1975, vol. 3, 73-99
- *Prog. Org. Coat,* 1981, vol. 9, 3-28
- **VON D.A. WICKS ; Z.W. WICKS.** *Prog. Org. Coat.,* 1999, vol. 36, 148-172
- *Prog. Org. Coat.,* 2001, vol. 41, 1-83
- **HOUBEN-WEYL.** Methoden der Organischen Chemie. Georg Thieme Verlag, 1963, vol. XIV/2, 61 ff